(19) Europäisches Patentamt
European Patent Office
Office européen des brevets

(11) **EP 4 322 406 A1**

(12) **EUROPEAN PATENT APPLICATION**
published in accordance with Art. 153(4) EPC

(43) Date of publication:
**14.02.2024  Bulletin 2024/07**

(21) Application number: **22794237.2**

(22) Date of filing: **28.01.2022**

(51) International Patent Classification (IPC):
**H03H 9/02** *(2006.01)*

(52) Cooperative Patent Classification (CPC):
**H03H 9/02; H03H 9/17**

(86) International application number:
**PCT/CN2022/074812**

(87) International publication number:
**WO 2022/227756 (03.11.2022 Gazette 2022/44)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **30.04.2021  CN 202110484760
29.07.2021  CN 202110866593
29.07.2021  CN 202121757671 U**

(71) Applicant: **Huawei Technologies Co., Ltd.
Longgang
Shenzhen, Guangdong 518129 (CN)**

(72) Inventors:
• WU, Wei
  Shenzhen, Guangdong 518129 (CN)
• LI, Wei
  Shenzhen, Guangdong 518129 (CN)
• WANG, Jinhui
  Shenzhen, Guangdong 518129 (CN)
• LI, Hao
  Shenzhen, Guangdong 518129 (CN)
• SU, Hongliang
  Shenzhen, Guangdong 518129 (CN)

(74) Representative: **Pfenning, Meinig & Partner mbB
Patent- und Rechtsanwälte
Theresienhöhe 11a
80339 München (DE)**

(54) **RESONATOR AND ELECTRONIC COMPONENT**

(57)    This application discloses a resonator and an electronic component and relates to the field of acoustic wave frequency selection technologies. The resonator includes a substrate (1), a first electrode layer (2), a piezoelectric layer (3) and a second electrode layer (4) sequentially stacked. At least one of the first electrode layer (2) and the second electrode layer (4) includes a first protrusion (6). The first protrusion (6) protrudes toward the piezoelectric layer (3). The first protrusion (6) includes a first edge protrusion (61), the first edge protrusion (61) surrounds at least a part of a side of the piezoelectric layer (3). According to this application, acoustic waves can be converged at a central axis of the piezoelectric layer (3), to enhance a convergence effect of the acoustic waves, reduce transverse leakage of the acoustic waves, increase a Q value of a bulk acoustic wave resonator, and reduce an insertion loss. In addition, enhancement of the convergence effect of the acoustic waves can reduce a spurious acoustic wave, suppress a transverse spurious mode, and improve a phase noise characteristic of the bulk acoustic wave resonator, thereby achieving a pure frequency of an electrical signal output by the bulk acoustic wave resonator.

FIG. 3

EP 4 322 406 A1

## Description

This application claims priorities to Chinese Patent Application No. 202110484760.4, filed on April 30, 2021 and entitled "CLOCK OSCILLATOR", to Chinese Patent Application No. 202110866593.X, filed on July 29, 2021 and entitled "RESONATOR AND ELECTRONIC COMPONENT", and to Chinese Patent Application No. 202121757671.4, filed on July 29, 2021 and entitled "RESONATOR AND ELECTRONIC COMPONENT", all of which are incorporated herein by reference in their entireties.

## TECHNICAL FIELD

This application relates to the field of acoustic wave frequency selection technologies, and in particular, to a resonator and an electronic component.

## BACKGROUND

Resonators are devices for electrical frequency selection through acoustic wave resonance, and are widely used in electronic components such as an oscillator and a filter.

Structurally, a resonator mainly sequentially includes: a substrate, a first electrode layer, a piezoelectric layer, and a second electrode layer from bottom to top.

A working principle of the resonator is as follows: An electric field is generated between the first electrode layer and the second electrode layer by supplying an electrical signal to the resonator, to cause the piezoelectric layer to vibrate mechanically in the electric field, thereby implementing conversion of electric energy to mechanical energy. In addition, the mechanical vibration of the piezoelectric layer can generate positive and negative charges on an upper surface and a lower surface of the piezoelectric layer to output an electrical signal, thereby implementing conversion of mechanical energy to electric energy. In the mechanical vibration of the piezoelectric layer, mechanical vibration with a vibration frequency quite different from a natural frequency (also referred to as a resonance frequency) of the piezoelectric layer is gradually attenuated, and mechanical vibration with a vibration frequency close to the natural frequency is retained. The retained mechanical vibration causes the resonator to output electrical signals outward. Therefore, the resonator outputs an electrical signal with a single frequency outward, to implement electrical frequency selection.

An acoustic wave is generated when the mechanical vibration propagates in the piezoelectric layer. However, when the acoustic wave propagates in the piezoelectric layer, transverse leakage is prone to occur. As a result, a quality factor (quality factor, Q) of the resonator is low, and an insertion loss of the resonator is large.

## SUMMARY

This application provides a resonator and an electronic component, to relieve the problem of transverse leakage of an acoustic wave in a related technology. The technical solutions are as follows.

In one aspect, a resonator is provided. The resonator includes a substrate, a first electrode layer, a piezoelectric layer, and a second electrode layer sequentially stacked.

At least one of the first electrode layer and the second electrode layer includes a first protrusion portion. The first protrusion protrudes toward the piezoelectric layer.

The first protrusion includes at least a first edge protrusion. The first edge protrusion surrounds at least a part of a side of the piezoelectric layer.

In the solution shown in this application, the first electrode layer includes the first protrusion, or the second electrode layer includes the first protrusion, or the first electrode layer and the second electrode layer each include the first protrusion. No matter which electrode layer includes the first protrusion, the included first protrusion protrudes toward the piezoelectric layer, and the included first protrusion includes at least the first edge protrusion.

In this way, when there is an electric field between the first electrode layer and the second electrode layer, a direction of electric field strength between the first electrode layer and the second electrode layer is biased toward a center of the first electrode layer or the second electrode layer. A propagation direction of an acoustic wave propagating inside the piezoelectric layer is related to the direction of the electric field strength of the electric field, so that acoustic waves propagating inside the piezoelectric layer converge at a central axis of the piezoelectric layer, thereby enhancing a convergence effect of acoustic waves, reducing transverse leakage of the acoustic wave, increasing a Q value, and reducing an insertion loss of the resonator.

In addition, enhancement of the convergence effect of the acoustic waves can attenuate a spurious acoustic wave and further reduce the spurious acoustic wave, where the spurious acoustic wave is an acoustic wave having transverse component in the propagation direction, which is parallel to the piezoelectric layer. Reduction of the spurious acoustic wave can well suppress a transverse spurious mode generated during propagation of the spurious acoustic wave. Suppression of the transverse spurious mode can reduce a phase noise of the resonator, and improve a phase noise characteristic, so that a frequency of an electrical signal output by the resonator is pure.

In a possible implementation, the first protrusion further includes one or more first inner protrusions.

The first edge protrusion and the one or more first inner protrusions are sequentially arranged from outside to inside, with heights decreasing sequentially.

According to the solution shown in this application, the first protrusion may not only include the first edge protrusion, but also include the one or more first inner protrusions. To make the direction of the electric field strength between the first electrode layer and the second electrode layer bias toward the center of the first electrode layer or the second electrode layer, the first edge protrusion and the at least one first inner protrusion are arranged from the outside to the inside, with heights decreasing sequentially. In this way, the closer to an edge, the stronger the electric field strength between the two electrode layers. The electric field strength between the two electrode layers is smallest at the center. Further, after the electric field strength between the two electrode layers is superposed, the electric field strength is biased toward the center of the first electrode layer or the second electrode layer, so that the direction of the electric field strength between the two electrode layers converges at the central axis of the piezoelectric layer.

In a possible implementation, the first edge protrusion and the one or more first inner protrusions are concentrically arranged.

According to the solution shown in this application, the first edge protrusion and the one or more first inner protrusions are concentrically arranged, so that the direction of the electric field strength is biased toward a position close to the center of the first electrode layer or the second electrode layer, and an electric field line of the electric field has a good convergence effect.

In a possible implementation, the first protrusion is a Fresnel mirror structure. Spherical centers of spherical surfaces of the first protrusion and a center of the piezoelectric layer are all located on the same side of a main body on which the first protrusion is located.

The Fresnel mirror structure is a structure including a plurality of concentrically arranged spherical surfaces.

According to the solution shown in this application, the first protrusion is the Fresnel mirror structure. The direction of the electric field strength between the first electrode layer and the second electrode layer can be enabled to bias toward the first electrode layer or the second electrode layer, to cause acoustic waves propagating inside the piezoelectric layer to converge at the central axis of the piezoelectric layer, thereby reducing a spurious acoustic wave and reducing transverse leakage of an acoustic wave. In addition, when the acoustic wave propagating inside the piezoelectric layer propagates to an interface between the piezoelectric layer and the electrode layer including the first protrusion, the acoustic wave is reflected, and the acoustic wave is reflected toward a position close to the center of the piezoelectric layer, causing acoustic waves to converge at the central axis of the piezoelectric layer, thereby reducing the transverse leakage of the acoustic wave and reducing the spurious acoustic wave. It can be learned that the first protrusion that is a Fresnel mirror structure can further reduce transverse leakage of an acoustic wave, increase a Q value of a resonator, and reduce an energy loss. In addition, a spurious acoustic wave can be further reduced and a transverse spurious mode generated during propagation of the spurious acoustic wave can be suppressed, so that a phase noise of the resonator is reduced, and a phase noise characteristic of the resonator is improved, thereby achieving a pure frequency of the electrical signal output by the resonator.

In a possible implementation, a cross-sectional shape of the first protrusion along a height direction is rectangular.

According to the solution shown in this application, the cross-sectional shape of the first protrusion along the height direction may be rectangular, so that the direction of the electric field strength between the first electrode layer and the second electrode layer is enabled to bias toward the first electrode layer or the second electrode layer, to cause acoustic waves propagating inside the piezoelectric layer to converge at the central axis of the piezoelectric layer, thereby reducing transverse leakage of an acoustic wave and reducing a spurious acoustic wave.

In a possible implementation, a cross-sectional shape of the first protrusion along the height direction is right triangular. An inclined surface of the first protrusion is in contact with the piezoelectric layer. A normal line of the inclined surface points to the center of the piezoelectric layer.

According to the solution shown in this application, the direction of the electric field strength between the first electrode layer and the second electrode layer can be enabled to bias toward the first electrode layer or the second electrode layer, to cause acoustic waves propagating inside the piezoelectric layer to converge at the central axis of the piezoelectric layer, thereby reducing transverse leakage of an acoustic wave and reducing a spurious acoustic wave. In addition, when the acoustic wave propagating inside the piezoelectric layer propagates to an interface between the piezoelectric layer and the electrode layer including the first protrusion, the acoustic wave is reflected, and the acoustic wave is reflected toward a position close to the center of the piezoelectric layer, causing acoustic waves to converge at the central axis of the piezoelectric layer, thereby reducing the transverse leakage of the acoustic wave and reducing the spurious acoustic wave. It can be learned that the first protrusion having the inclined surface can further reduce transverse leakage of an acoustic wave, increase a Q value of the resonator, and reduce an energy loss. In addition, a spurious acoustic wave can be further reduced and a transverse spurious mode generated during propagation of the spurious acoustic wave can be suppressed, so that a phase noise of the resonator is reduced, and a phase noise characteristic of the resonator is improved, thereby achieving a pure frequency of the electrical signal output by the resonator.

In a possible implementation, at least one of the first electrode layer or the second electrode layer further includes a second protrusion. The second protrusion is located on a surface that is of the main body and that is distant from the piezoelectric layer.

The second protrusion includes at least a second edge protrusion. The second edge protrusion is close to a side of the main body on which the second edge protrusion is located.

According to the solution shown in this application, the electric field strength at the edge of the electric field between the first electrode layer and the second electrode layer can be further enhanced. A direction of the electric field strength between the first electrode layer and the second electrode layer after being superposed is better biased toward the center of the first electrode layer or the second electrode layer by using the first edge protrusion and the second edge protrusion. Once the convergence effect of the electric field strength is enhanced, the effect of converging the acoustic wave at the central axis of the piezoelectric layer is stronger, transverse leakage of an acoustic wave is further reduced, and a Q value of the resonator is increased. Because the effect of converging the acoustic wave at the central axis of the piezoelectric layer is enhanced, a spurious acoustic wave can be further reduced and a transverse spurious mode generated during propagation of the spurious acoustic wave can be suppressed, so that a phase noise of the resonator is reduced, and a phase noise characteristic of the resonator is improved, thereby achieving a pure frequency of the electrical signal output by the resonator.

In a possible implementation, the second protrusion further includes one or more second inner protrusions.

The second edge protrusion and the one or more second inner protrusions are sequentially arranged from outside to inside, with heights decreasing sequentially.

According to the solution shown in this application, the second protrusion may not only include the second edge protrusion, but also include one or more second inner protrusions. To make the direction of the electric field strength between the first electrode layer and the second electrode layer bias toward the center of the first electrode layer or the second electrode layer, the second edge protrusion and the at least one second inner protrusion are arranged from the outside to the inside, with heights decreasing sequentially. In this way, the closer to the edge, the stronger the electric field strength between the two electrode layers. The electric field strength between the two electrode layers is smallest at the center. Further, after the electric field strength between the two electrode layers is superposed, the electric field strength is biased toward the first electrode layer or the second electrode layer.

In a possible implementation, the second edge protrusion and the one or more second inner protrusions are concentrically arranged.

According to the solution shown in this application, the second edge protrusion and the one or more second inner protrusions are concentrically arranged, so that the direction of the electric field strength is biased toward the position close to the center of the first electrode layer or the second electrode layer, and the electric field line of the electric field has a good convergence effect.

In a possible implementation, the second protrusion is a Fresnel mirror structure. Spherical centers of spherical surfaces of the second protrusion and the center of the piezoelectric layer are all located on the same side of the main body on which the second protrusion is located.

According to the solution shown in this application, the second protrusion is a Fresnel mirror structure. The direction of the electric field strength between the first electrode layer and the second electrode layer can be enabled to bias toward the first electrode layer or the second electrode layer, to cause acoustic waves propagating inside the piezoelectric layer to converge at the central axis of the piezoelectric layer, thereby reducing a spurious acoustic wave and reducing transverse leakage of an acoustic wave. In addition, when the acoustic wave propagating inside the piezoelectric layer propagates to the interface between the piezoelectric layer and the electrode layer including the second protrusion, the acoustic wave is reflected, and the acoustic wave is reflected toward the position close to the center of the piezoelectric layer, causing acoustic waves to converge at the central axis of the piezoelectric layer, thereby reducing the transverse leakage of the acoustic wave and reducing the spurious acoustic wave. It can be learned that the second protrusion that is the Fresnel mirror structure can further reduce transverse leakage of an acoustic wave, increase a Q value of the resonator, and reduce an energy loss. In addition, a spurious acoustic wave can be further reduced and a transverse spurious mode generated by the spurious acoustic wave can be suppressed, so that a phase noise of the resonator is reduced, and a phase noise characteristic of the resonator is improved, thereby achieving a pure frequency of the electrical signal output by the resonator.

In a possible implementation, a cross-sectional shape of the second protrusion along the height direction is rectangular.

According to the solution shown in this application, the cross-sectional shape of the second protrusion along the height direction may also be rectangular, so that the direction of the electric field strength between the first electrode layer and the second electrode layer is enabled to bias toward the first electrode layer or the second electrode layer, to cause acoustic waves propagating inside the piezoelectric layer to converge at the central axis of the piezoelectric layer, thereby reducing transverse leakage of an acoustic wave and reducing a spurious acoustic wave.

In a possible implementation, a cross-sectional shape of the second protrusion along the height direction is right triangular. An inclined surface of the second protrusion is distant from the piezoelectric layer. A normal line of the inclined surface points to the center of the piezoelectric layer.

According to the solution shown in this application, the direction of the electric field strength between the first electrode layer and the second electrode layer can be enabled to bias toward the first electrode layer or the second electrode layer, to cause acoustic waves propagating inside the piezoelectric layer to converge at the central axis of the piezoelectric layer, thereby reducing transverse leakage of an acoustic wave and reducing a spurious acoustic wave. In addition, when the acoustic wave propagating inside the piezoelectric layer propagates to the interface between the piezoelectric layer and the electrode layer including the second protrusion, the acoustic wave is reflected, and the acoustic wave is reflected toward the position close to the center of the piezoelectric layer, causing acoustic waves to converge at the central axis of the piezoelectric layer, thereby reducing the transverse leakage of the acoustic wave and reducing the spurious acoustic wave. It can be learned that the second protrusion having the inclined surface can further reduce transverse leakage of an acoustic wave, increase a Q value of the resonator, and reduce an energy loss. In addition, a spurious acoustic wave can be further reduced and a transverse spurious mode generated by the spurious acoustic wave can be suppressed, so that a phase noise of the resonator is reduced, and a phase noise characteristic of the resonator is improved, thereby achieving a pure frequency of the electrical signal output by the resonator.

According to another aspect, a resonator is provided. The resonator includes a substrate, a first electrode layer, a piezoelectric layer, and a second electrode layer sequentially stacked.

The first electrode layer includes a main body and a second protrusion, and the second protrusion is located on a surface that is of the main body and that is distant from the piezoelectric layer.

The second protrusion includes at least a second edge protrusion. The second edge protrusion is close to a side of the main body.

According to the solution shown in this application, the first electrode layer includes the second protrusion that is distant from the piezoelectric layer. The second protrusion includes the second edge protrusion. In this way, electric field strength of an electric field between the first electrode layer and the second electrode layer at an edge is greater than the field strength at a center, so that a direction of the electric field strength between the first electrode layer and the second electrode layer is biased toward a center of the first electrode layer or the second electrode layer. A propagation direction of an acoustic wave propagating inside the piezoelectric layer is related to the direction of the electric field strength of the electric field, so that acoustic waves propagating inside the piezoelectric layer converge at a central axis of the piezoelectric layer, thereby enhancing a convergence effect of acoustic waves, reducing transverse leakage of an acoustic wave, increasing a Q value of the resonator, and reducing an energy loss. In addition, enhancement of the convergence effect of the acoustic waves can further reduce a spurious acoustic wave and suppress a transverse spurious mode generated by the spurious acoustic wave, so that a phase noise of the resonator is reduced, and a phase noise characteristic of the resonator is improved, thereby achieving a pure frequency of an electrical signal output by the resonator.

In a possible implementation, the second protrusion further includes one or more second inner protrusions.

The second edge protrusion and the one or more second inner protrusions are sequentially arranged from outside to inside, with heights decreasing sequentially.

According to the solution shown in this application, the second protrusion may not only include the second edge protrusion, but also include one or more second inner protrusions. To make the direction of the electric field strength between the first electrode layer and the second electrode layer bias toward the center of the first electrode layer or the second electrode layer, the second edge protrusion and the at least one second inner protrusion are arranged from the outside to the inside, with heights decreasing sequentially. In this way, the closer to the edge, the stronger the electric field strength between the two electrode layers. The electric field strength between the two electrode layers is smallest at the center. Further, after the electric field strength between the two electrode layers is superposed, the electric field strength is biased toward the first electrode layer or the second electrode layer.

In a possible implementation, the second edge protrusion and the one or more second inner protrusions are concentrically arranged.

According to the solution shown in this application, the second edge protrusion and the one or more second inner protrusions are concentrically arranged, so that the direction of the electric field strength is biased toward a position close to the center of the first electrode layer or the second electrode layer, and an electric field line of the electric field has a good convergence effect.

In a possible implementation, the second protrusion is a Fresnel mirror structure. Spherical centers of spherical surfaces of the second protrusion and the center of the piezoelectric layer are all located on the same side of the main body on which the second protrusion is located.

According to the solution shown in this application, the second protrusion is the Fresnel mirror structure. The direction of the electric field strength between the first electrode layer and the second electrode layer can be enabled to bias toward the first electrode layer or the second electrode layer, to cause acoustic waves propagating inside the piezoelectric layer to converge at the central axis of the piezoelectric layer, thereby reducing transverse leakage of an acoustic wave and reducing a spurious acoustic wave. In addition, when the acoustic wave propagating inside the piezoelectric layer propagates to the interface between the piezoelectric layer and the electrode layer including the second protrusion, the acoustic wave is reflected, and the acoustic wave is reflected toward the position close to the center of the piezoelectric layer, causing acoustic waves to converge at the central axis of the piezoelectric layer, thereby reducing the transverse leakage of the acoustic wave and reducing the spurious acoustic wave. It can be learned that the second protrusion that is the Fresnel mirror structure can further reduce transverse leakage of an acoustic wave, increase a Q value of the resonator, and reduce an energy loss. In addition, a spurious acoustic wave can be further reduced and a transverse spurious mode generated by the spurious acoustic wave can be suppressed, so that a phase noise of the resonator is reduced, and a phase noise characteristic of the resonator is improved, thereby achieving a pure frequency of the electrical signal output by the resonator.

In a possible implementation, a cross-sectional shape of the second protrusion along a height direction is rectangular.

According to the solution shown in this application, the cross-sectional shape of the second protrusion along the height direction may also be rectangular, so that the direction of the electric field strength between the first electrode layer and the second electrode layer is enabled to bias toward the first electrode layer or the second electrode layer, to cause acoustic waves propagating inside the piezoelectric layer to converge at the central axis of the piezoelectric layer, thereby reducing transverse leakage of an acoustic wave and reducing a spurious acoustic wave.

In a possible implementation, a cross-sectional shape of the second protrusion along the height direction is right triangular. An inclined surface of the second protrusion is distant from the piezoelectric layer. A normal line of the inclined surface points to the center of the piezoelectric layer.

According to the solution shown in this application, the direction of the electric field strength between the first electrode layer and the second electrode layer can be enabled to bias toward the first electrode layer or the second electrode layer, to cause acoustic waves propagating inside the piezoelectric layer to converge at the central axis of the piezoelectric layer, thereby reducing transverse leakage of an acoustic wave and reducing a spurious acoustic wave. In addition, when the acoustic wave propagating inside the piezoelectric layer propagates to the interface between the piezoelectric layer and the electrode layer including the second protrusion, the acoustic wave is reflected, and the acoustic wave is reflected toward the position close to the center of the piezoelectric layer, causing acoustic waves to converge at the central axis of the piezoelectric layer, thereby reducing the spurious acoustic wave. It can be learned that the second protrusion having the inclined surface can further reduce transverse leakage of an acoustic wave, increase a Q value of the resonator, and reduce an energy loss. In addition, a spurious acoustic wave can be further reduced and a transverse spurious mode generated by the spurious acoustic wave can be suppressed, so that a phase noise of the resonator is reduced, and a phase noise characteristic of the resonator is improved, thereby achieving a pure frequency of the electrical signal output by the resonator.

According to another aspect, a resonator is provided. The resonator includes a substrate, a first electrode layer, a piezoelectric layer, and a second electrode layer sequentially stacked.

A distance between the first electrode layer and the second electrode layer sequentially decreases from a center to an edge.

According to the solution shown in this application, the distance between the first electrode layer and the second electrode layer sequentially decreases from the center to the edge. Electric field strength close to the edge between the first electrode layer and the second electrode layer is enhanced by reducing the distance between the first electrode layer and the second electrode layer, so that a direction of the electric field strength between the first electrode layer and the second electrode layer is biased toward a center of the first electrode layer or the second electrode layer. In this way, acoustic waves propagating inside the piezoelectric layer are caused to converge at the position close to a central axis of the piezoelectric layer, thereby enhancing a convergence effect of acoustic waves, reducing transverse leakage of an acoustic wave, increasing a Q value of the resonator, and reducing an energy loss. In addition, enhancement of the convergence effect of the acoustic waves can further reduce a spurious acoustic wave and suppress a transverse spurious mode generated by the spurious acoustic wave, so that a phase noise of the resonator is reduced, and a phase noise characteristic of the resonator is improved, thereby achieving a pure frequency of an electrical signal output by the resonator.

In a possible implementation, a first surface that is of at least one of the first electrode layer and the second electrode layer and that is close to the piezoelectric layer is one of a spherical surface, a conical surface, and paraboloid. A center of the piezoelectric layer is located in a region defined by the first surface.

According to the solution shown in this application, the electric field strength close to the edge between the first electrode layer and the second electrode layer can be enhanced by reducing the distance between the first electrode layer and the second electrode layer, so that the direction of the electric field strength between the first electrode layer and the second electrode layer is biased toward the center of the first electrode layer or of the second electrode layer. In this way, acoustic waves propagating inside the piezoelectric layer are caused to converge at the position close to the central axis of the piezoelectric layer, thereby enhancing a convergence effect of acoustic waves, reducing transverse leakage of an acoustic wave, increasing a Q value of the resonator, and reducing an energy loss. In addition, enhancement of the convergence effect of the acoustic waves can further reduce a spurious acoustic wave and suppress a transverse spurious mode generated by the spurious acoustic wave, so that a phase noise of the resonator is reduced, and a phase noise characteristic of the resonator is improved, thereby achieving a pure frequency of the electrical signal output by the resonator.

In addition, when the acoustic wave in the piezoelectric layer propagates to junction between the piezoelectric layer and the first electrode layer, the acoustic wave can be reflected toward the position close to the center of the piezoelectric layer. In this way, acoustic waves propagating inside the piezoelectric layer are caused to converge at the position close to the central axis of the piezoelectric layer, thereby enhancing a convergence effect of acoustic waves, reducing transverse leakage of an acoustic wave, increasing a Q value of the resonator, and reducing an energy loss. In addition, enhancement of the convergence effect of the acoustic waves can further reduce a spurious acoustic wave and suppress a transverse spurious mode generated by the spurious acoustic wave, so that a phase noise of the resonator is reduced, and a phase noise characteristic of the resonator is improved, thereby achieving a pure frequency of the electrical signal output by the resonator.

According to another aspect, an electronic component is provided. The electronic component includes any one of the foregoing resonators.

According to the solution shown in this application, the resonator of the electronic component, as described above, can enhance electric field strength close to an edge between a first electrode layer and a second electrode layer, so that a direction of the electric field strength between the first electrode layer and the second electrode layer is biased toward the first electrode layer or the second electrode layer. In this way, an acoustic wave propagating inside a piezoelectric layer is caused to converge at a position close to a central axis of the piezoelectric layer, thereby enhancing a convergence effect of acoustic waves, reducing transverse leakage of an acoustic wave, increasing a Q value of the resonator, and reducing an energy loss. In addition, enhancement of the convergence effect of the acoustic waves can further reduce the spurious acoustic wave, suppress the transverse spurious mode generated by the spurious acoustic wave, reduce the phase noise of the resonator, and improve the phase noise characteristic of the resonator, thereby achieving a pure frequency of an electrical signal output by the resonator.

## BRIEF DESCRIPTION OF DRAWINGS

FIG. 1 is a schematic diagram of a structure of a resonator according to related technologies, in which (a) is a schematic diagram of a structure of a film bulk acoustic resonator, and (b) is a schematic diagram of a structure of a solidly-mounted resonator;
FIG. 2 is a schematic exploded view of a structure of a resonator according to this application;
FIG. 3 is a schematic diagram of a structure of a resonator according to this application;
FIG. 4 is a schematic diagram of a structure of a resonator according to this application;
FIG. 5 is a schematic diagram of a structure of a resonator according to this application;
FIG. 6 is a schematic diagram of an electric field distribution between a first electrode layer and a second electrode layer of a resonator according to this application;
FIG. 7 is a schematic exploded view of a structure of a resonator according to this application;
FIG. 8 is a schematic diagram of a structure of a resonator according to this application;
FIG. 9 is a schematic diagram of a structure of a resonator according to this application;
FIG. 10 is a schematic diagram of a structure of a resonator according to this application;
FIG. 11 is a schematic diagram of a structure of a resonator according to this application;
FIG. 12 is a schematic diagram of a structure of a resonator according to this application;
FIG. 13 is a schematic diagram of a structure of a resonator according to this application;
FIG. 14 is a schematic diagram of a structure of a resonator according to this application, in which (a) is a schematic diagram of a structure of a resonator in which a surface of a first protrusion is a spherical surface or paraboloid, and (b) is a schematic diagram of a structure of a resonator in which a surface of a first protrusion includes an inclined surface;
FIG. 15 is a schematic exploded view of a structure of a resonator according to this application;
FIG. 16 is a schematic diagram of a structure of a resonator according to this application;
FIG. 17 is a schematic diagram of a structure of a resonator according to this application;
FIG. 18 is a schematic diagram of a structure of a resonator according to this application;
FIG. 19 is a schematic diagram of a structure of a resonator according to this application;
FIG. 20 is a schematic diagram of a result of a simulation based on that a second electrode layer includes a first protrusion according to this application, in which (a) is a schematic diagram of a result of a simulation based on that a reflection layer is laid on the second electrode layer, and (b) is a schematic diagram of a result of a simulation based on that no reflection layer is laid on the second electrode layer;
FIG. 21 is a schematic exploded view of a structure of a resonator according to this application;

FIG. 22 is a schematic diagram of a structure of a resonator according to this application;

FIG. 23 is a schematic diagram of a structure of a resonator according to this application;

FIG. 24 is a schematic diagram of a structure of a resonator according to this application;

FIG. 25 is a schematic diagram of a structure of a resonator according to this application;

FIG. 26 is a schematic diagram of a structure of a resonator according to this application;

FIG. 27 is a schematic diagram of a structure of a resonator according to this application;

FIG. 28 is a schematic diagram of a structure of a resonator according to this application; and

FIG. 29 is a schematic diagram of a structure of a resonator according to this application.

Reference numerals:

1. substrate; 101. cavity; 102. Bragg reflection layer;
2. first electrode layer; 3. piezoelectric layer; 4. second electrode layer;
5. main body; 6. first protrusion; 7. second protrusion;
61. first edge protrusion; 62. first inner protrusion;
71. second edge protrusion; 72. second inner protrusion; and
a. side.

## DESCRIPTION OF EMBODIMENTS

Embodiments of this application provide a resonator. The resonator is a device for electrical frequency selection through acoustic wave resonance, and is widely used in electronic components such as an oscillator and a filter.

A resonator may be a bulk acoustic wave (bulk acoustic wave, BAW) resonator. A bulk acoustic wave is relative to the concept of a surface acoustic wave (surface acoustic wave, SAW). The acoustic wave propagates inside an object, while the surface acoustic wave propagates along a surface of a solid.

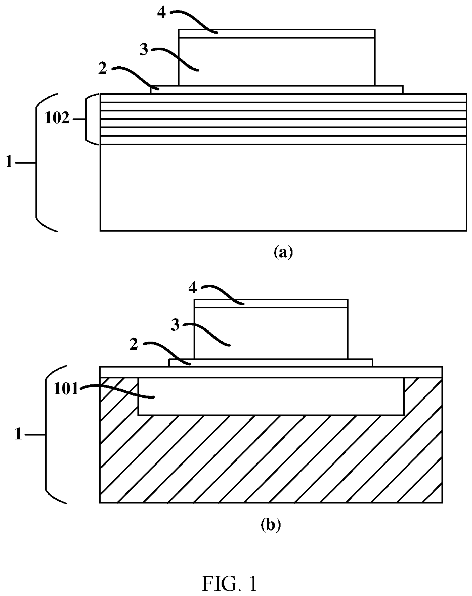

A basic structure of the resonator is that a piezoelectric layer 3 is sandwiched between a first metal electrode layer 2 and a second metal electrode layer 4 to form a sandwich-like structure, as shown in FIG. 1. The piezoelectric layer 3 may also be referred to as a piezoelectric film. A slight deformation occurs when there is a voltage between two opposite surfaces of the piezoelectric layer 3, such that an acoustic wave is generated. In addition, when the piezoelectric layer 3 is pressed, a voltage is generated. A principle of generating an acoustic wave and a voltage by the piezoelectric layer 3 may be as follows.

When there is an electric field between the first electrode layer 2 and the second electrode layer 4, because the voltage exists inside the piezoelectric layer 3, atoms inside the piezoelectric layer 3 vibrates back and forth to maintain charge balance, resulting in deformation in a shape of the piezoelectric layer 3, so that the acoustic wave is generated inside the piezoelectric layer 3. Such a process is referred to as an inverse piezoelectric effect, and implements conversion of electric energy to mechanical energy. During propagation of the acoustic wave inside the piezoelectric layer 3, spacings between some atoms become smaller or larger. This disrupts the previously maintained balance, resulting in occurrence of net charges. The net charges are uncanceled charges carried on an object or a part of the object. As a result, there are positive charges and negative charges on the surfaces of the piezoelectric layer 3, to generate an electrical signal. This process may be referred to as a piezoelectric effect, in which conversion of the mechanical energy to the electric energy is implemented.

As described above, a resonator is a device for electrical frequency selection through acoustic wave resonance. A principle of the resonator may be as follows. Resonance is also referred to as resonance, and is a phenomenon that an amplitude of vibration of an object increases sharply when a vibration frequency of the object is the same as or close to a natural frequency of the object, where a frequency at which resonance is generated may be referred to as a resonance frequency. When the piezoelectric layer 3 vibrates under impact of the voltage, vibration with a frequency quite different from the natural frequency is gradually attenuated while vibration with a frequency the same as or close to the natural frequency is retained. Finally, the piezoelectric layer 3 vibrates at the resonant frequency. In this case, an electrical signal generated at the resonance frequency is an electrical signal with a pure frequency, implementing electrical frequency selection through acoustic wave resonance.

As described above, in the most basic structure of the resonator, the piezoelectric layer 3 is sandwiched between the first electrode layer 2 and the second electrode layer 4 to form the sandwich-like structure. However, because the piezoelectric layer 3 is thin, which is at a micron level, the substrate 1 is required to support the first electrode layer 2 and the second electrode layer 4. Therefore, as shown in FIG. 1, if a position where the substrate 1 is located is defined as bottom, the resonator sequentially includes the substrate 1, the first electrode layer 2, the piezoelectric layer 3, and the second electrode layer 4 from bottom to top.

It should be noted that the resonator in embodiments of this application may be a film bulk acoustic resonator (film bulk acoustic resonator, FBAR), or may be a solidly-mounted resonator (solidly-mounted resonator, SMR).

(a) in FIG. 1 shows a film bulk acoustic resonator. The film bulk acoustic resonator is a resonator having a cavity 101 in the substrate 1. As vacuum or air exists in the cavity 101, acoustic impedance is high. Therefore, during transmission, acoustic waves can be well reflected to the piezoelectric layer 3 when encountering the cavity 101 of the substrate 1, restricting propagation of the acoustic waves to be within the piezoelectric layer 3. Such resonator has a high Q value.

(b) in FIG. 1 shows a solidly-mounted resonator. The substrate 1 includes a Bragg reflection layer 102, which is a structure formed by a series of alternately arranged high-impedance and low-impedance acoustic reflection layers, so that acoustic waves can be well reflected to the piezoelectric layer 3, restricting propagation of the acoustic waves to be within the piezoelectric layer 3.

An improvement of the resonator in embodiments lies in a structure of the first electrode layer 2 and/or the second electrode layer 4. The resonator in embodiments may be used in the thin film bulk acoustic resonator or the solidly-mounted resonator.

For a resonator, when acoustic waves propagate in the piezoelectric layer 3, a higher degree of convergence of the acoustic waves on a central axis of the piezoelectric layer 3 indicates less transverse leakage of the acoustic wave, so that a quality factor (quality factor, Q) of the resonator is increased and an insertion loss of the resonator is reduced.

The transverse leakage, for example, may be leakage of an acoustic wave along a direction parallel to the piezoelectric layer 3.

Q is a parameter representing an insertion loss of a resonator. A higher Q value of the resonator indicates a lower insertion loss of the resonator. The insertion loss may also be referred to as an insertion loss, and is a loss of energy or a gain produced when a device is added into a circuit.

The resonator performs frequency selection mainly using an acoustic wave with a propagation direction perpendicular to the piezoelectric layer 3. A vibration mode generated during propagation of the acoustic wave may be referred to as a longitudinal acoustic wave mode, which is desirable.

Among acoustic waves propagating inside the piezoelectric layer 3, in addition to the acoustic wave with a propagation direction perpendicular to the piezoelectric layer 3, there are an acoustic wave with a propagation direction parallel to the piezoelectric layer 3 and an acoustic wave with a propagation direction intersecting with the piezoelectric layer 3 but not perpendicular to the piezoelectric layer 3. These two acoustic waves may be collectively referred to as spurious acoustic waves. It can be learned that the spurious acoustic wave is an acoustic wave having a transverse component in the propagation direction, where a transverse direction is a direction parallel to the piezoelectric layer 3. A vibration mode generated by the spurious acoustic wave during propagation may be referred to as a transverse acoustic wave mode. As the transverse mode is an undesired mode and needs to be suppressed, it may also be referred to as a transverse spurious mode.

The convergence of acoustic waves on the central axis of the piezoelectric layer 3 can attenuate the spurious acoustic wave, so as to reduce the spurious acoustic wave. This can suppress the transverse spurious mode generated during propagation of the spurious acoustic wave inside the piezoelectric layer 3, reduce a phase noise of the resonator is reduced, and improve a phase noise characteristic. The phase noise characteristic is an important indicator to evaluate spectral purity of the resonator. A better phase noise characteristic indicates a purer frequency of an electrical signal output by the resonator.

The resonator described in this solution can cause acoustic waves propagating inside the piezoelectric layer 3 to converge on the central axis of the piezoelectric layer 3 to achieve the foregoing effect.

The following describes a structure of a resonator in this application.

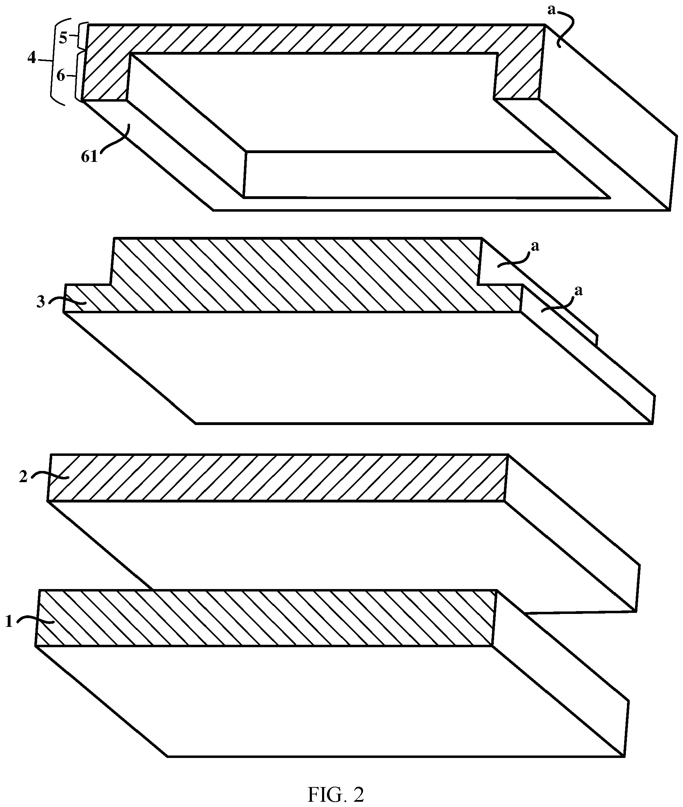

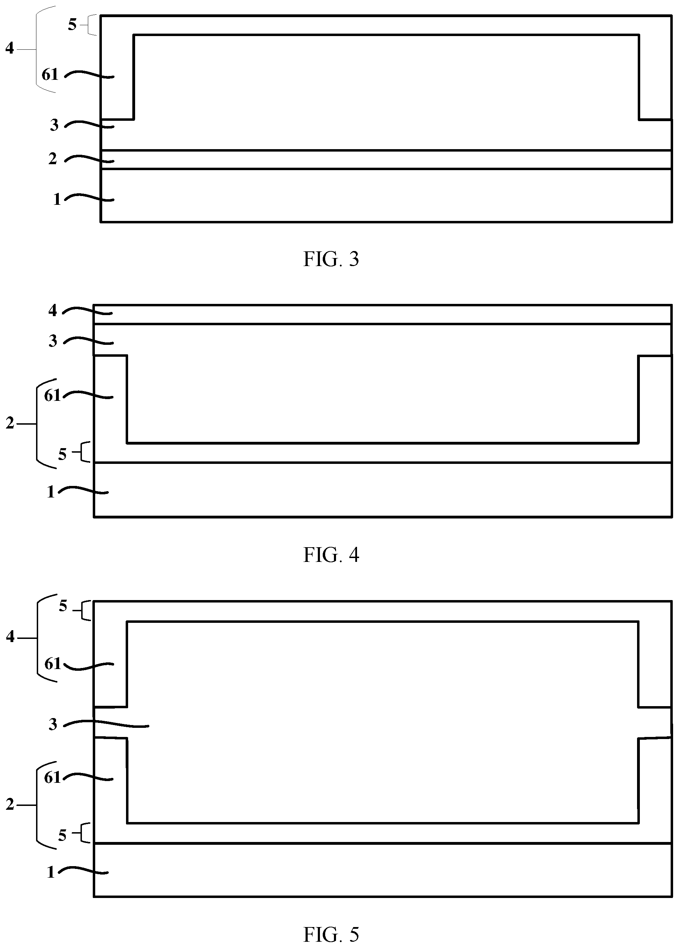

FIG. 2 is a schematic diagram of a longitudinal section of an exploded view of the resonator, where a cutting direction is along a height direction of the resonator. FIG. 3 is a cross sectional schematic view of the resonator, where a cutting direction is also along the height direction of the resonator. Unless otherwise specified, all cutting directions of cross sectional schematic views are along a thickness direction (the height direction) of the resonator in the following description.

As shown in FIG. 2, the resonator includes a substrate 1, a first electrode layer 2, a piezoelectric layer 3, and a second electrode layer 4. As shown in FIG. 3, the substrate 1, the first electrode layer 2, the piezoelectric layer 3, and the second electrode layer 4 are sequentially stacked. If a position where the substrate 1 is located is defined as bottom, the substrate 1, the first electrode layer 2, the piezoelectric layer 3, and the second electrode layer 4 are sequentially stacked from bottom to top.

As the first electrode layer 2 is located below the piezoelectric layer 3, the first electrode layer 2 is referred to as a lower electrode layer. As the second electrode layer 4 is located above the electrode layer 3, the second electrode layer 4 is referred to as an upper electrode layer.

As shown in FIG. 2, at least one of the first electrode layer 2 and the second electrode layer 4 includes a first protrusion 6, and the first protrusion 6 protrudes toward the piezoelectric layer 3. For example, at least one of the first electrode layer 2 and the second electrode layer 4 includes a main body 5 and the first protrusion 6. The first protrusion 6 is located on a surface of the main body 5 and protrudes toward the piezoelectric layer 3, and the main body 5 is a flat portion of the electrode layer.

As shown in FIG. 2, the first protrusion 6 may be in a shape of a ring. The ring may be a circular ring, or may be any polygonal ring, such as a triangular ring, a quadrilateral ring, or a pentagonal ring. A specific shape of the ring may be related to a contour shape of the resonator in a top view.

The ring of the first protrusion 6 may be a ring formed by a continuous protrusion shown in FIG. 2, or may be a ring formed by a plurality of protrusions. Two adjacent protrusions are in contact with each other or spaced apart from each other. A formation of the ring of the first protrusion 6 is not specifically limited in this embodiment. The ring shown in FIG. 2 may be used as an example.

As described above, at least one of the first electrode layer 2 and the second electrode layer 4 includes the first protrusion 6. For example, the second electrode layer 4 includes the first protrusion 6, as shown in FIG. 3; the first electrode layer 2 includes the first protrusion 6, as shown in FIG. 4; and the first electrode layer 2 and the second electrode layer 6 each include the first protrusion 6, as shown in FIG. 5.

Whether the first electrode layer 2 includes the first protrusion 6, the second electrode layer 4 includes the first protrusion 6, or the first electrode layer and the second electrode layer each include the first protrusion 6, the first protrusion 6 protrudes toward the piezoelectric layer 3. In other words, the first protrusion 6 is located on the surface of the main body 5, and is close to the piezoelectric layer 3.

In an example, the first protrusion 6 may include at least a first edge protrusion 61. The first edge protrusion 61 is located at an edge of the main body 5 on which the first edge protrusion 6 is located. An entire side of the main body 5 may be referred to as an edge of the main body 5.

As described above, if the first protrusion 6 is in a shape of a ring, the first edge protrusion 61 is also in a shape of a ring. As shown in FIG. 3, the ring of the first edge protrusion 61 may surround at least a part of a side a of the piezoelectric layer 3. For example, as shown in FIG. 3, the first edge protrusion 61 surrounds a part of the side a of the piezoelectric layer 3. For another example, the first edge protrusion 61 may surround the entire side a of the piezoelectric layer 3, and the first edge protrusion 61 is not electrically connected to an electrode layer on the opposite side, so that an electric field can be formed between the first electrode layer 2 and the second electrode layer 4.

In an example, the first electrode layer 2 includes the first edge protrusion 61, and the first edge protrusion 61 is not electrically connected to the second electrode layer 4. An electric field can be formed between the first electrode layer 2 and the second electrode layer 4. In another example, the second electrode layer 4 includes the first edge protrusion 61, and the first edge protrusion 61 is not electrically connected to the first electrode layer 2. An electric field can be formed between the first electrode layer 2 and the second electrode layer 4.

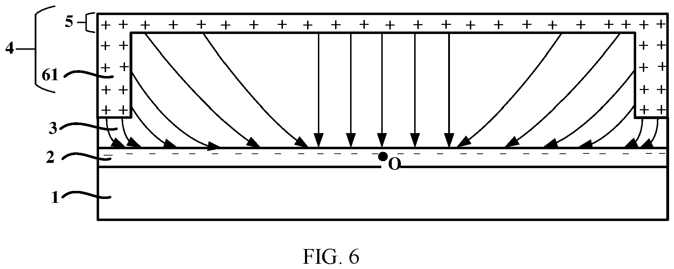

Because the first protrusion 6 protrudes relative to the main body 5, as shown in FIG. 6, more charges are accumulated on a surface of the first protrusion 6 than on a surface of the main body 5. A large quantity of charges indicates a strong electric field strength representing strength and a direction of an electric field. Further, because the first protrusion 6 includes the first edge protrusion 61, the electric field strength of the electric field at an edge between the first electrode layer 2 and the second electrode layer 4 is stronger than the electric field strength at a center.

The electric field strength is a vector with a magnitude and a direction. After the electric field strength between the first electrode layer 2 and the second electrode layer 4 is superposed, as shown in FIG. 6, a straight line with an arrow in FIG. 6 is an electric field line, and a tangent line of the electric field line represents the direction of the electric field strength. The direction of the electric field strength between a first electrode layer 2 and a second electrode layer 4 is biased toward a center O of the first electrode layer 2 or of the second electrode layer 4.

For example, as shown in FIG. 6, if the second electrode layer 4 is a positive electrode and the first electrode layer 2 is a negative electrode, the direction of the electric field strength between the first electrode layer 2 and the second electrode layer 4 is biased toward the center O of the first electrode layer 2. If the first electrode layer 2 is the positive electrode and the second electrode layer 4 is the negative electrode, the direction of the electric field strength between the first electrode layer 2 and the second electrode layer 4 is biased toward the center of the second electrode layer 4.

Because propagation of an acoustic wave in the piezoelectric layer 3 is related to the direction of the electric field strength between the first electrode layer 2 and the second electrode layer 4, the direction of the electric field strength is biased toward the center of the first electrode layer 2 or of the second electrode layer 4, the acoustic wave propagated in the piezoelectric layer 3 also converges at a central axis of the piezoelectric layer 3, thereby enhancing a convergence effect of acoustic waves, reducing transverse leakage of an acoustic wave, increasing a Q value, and reducing an insertion loss of the resonator.

In addition, once the convergence effect of the acoustic waves is enhanced, a spurious acoustic wave can be further reduced, so that a transverse spurious mode generated during propagation of the spurious acoustic wave can be suppressed, a phase noise of the resonator is reduced, and a phase noise characteristic of the resonator is improved, thereby achieving a pure frequency of an electrical signal output by the resonator.

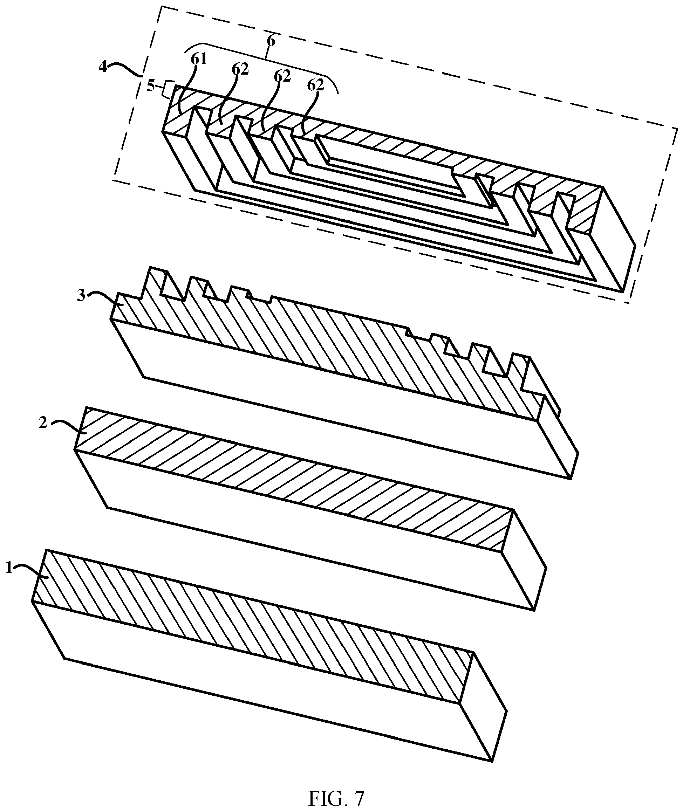

In an example, as shown in FIG. 2, the first protrusion 6 may include only the first edge protrusion 61. As shown in FIG. 7, the first protrusion 6 may include both a first edge protrusion 61 and at least one first inner protrusion 62. The first edge protrusion 61 and the at least one first inner protrusion 62 are sequentially arranged from outside to inside, with heights decreasing sequentially.

The heights of the first edge protrusion 61 and the at least one first inner protrusion 62 decrease sequentially, to cause the electric field strength between the first electrode layer 2 and the second electrode layer 4 to be in a decreasing distribution from outside to inside, that is, from the edge to the center, so that, as shown in FIG. 6, the direction of the electric field strength between the first electrode layer 2 and the second electrode layer 4 is biased toward the center of the first electrode layer 2 or the center of the second electrode layer 4.

In an example, as shown in FIG. 7, the first edge protrusion 61 and the one or more first inner protrusions 62 may be concentrically arranged.

In an example, the piezoelectric layer 3 is sandwiched between the first electrode layer 2 and the second electrode layer 4. Correspondingly, a lower surface of the piezoelectric layer 3 matches the first electrode layer 2, and an upper surface of the piezoelectric layer 3 matches the second electrode layer 4. For example, if the second electrode layer 4 includes the first protrusion 6, and the first protrusion 6 includes the first edge protrusion 61 and the first inner protrusion 62, as shown in FIG. 7, a side of the piezoelectric layer 3 is fitted with the first edge protrusion 61. The piezoelectric layer 3 includes a groove that is fitted with the first inner protrusion 62, for example, a groove depth of the groove is equal to a height of the first inner protrusion 62. In other words, a structure of the piezoelectric layer 3 is fitted with a structure of the first electrode layer 2, and the two structures are in an engagement state. The structure of the piezoelectric layer 3 also is fitted with a structure of the second electrode layer 4, and the two structures are also in an engagement state.

Formations and stacks of the substrate 1, the first electrode layer 2, the piezoelectric layer 3, and the second electrode layer 4 may be implemented by using an etching process. A specific formation process is described in detail in the following description of a processing manner of the resonator.

In an example, as shown in FIG. 7, a cross-sectional shape of the first protrusion 6 along the height direction may be rectangular. For example, cross-sectional shapes of the first edge protrusion 61 and the first inner protrusion 62 of the first protrusion 6 may be rectangular.

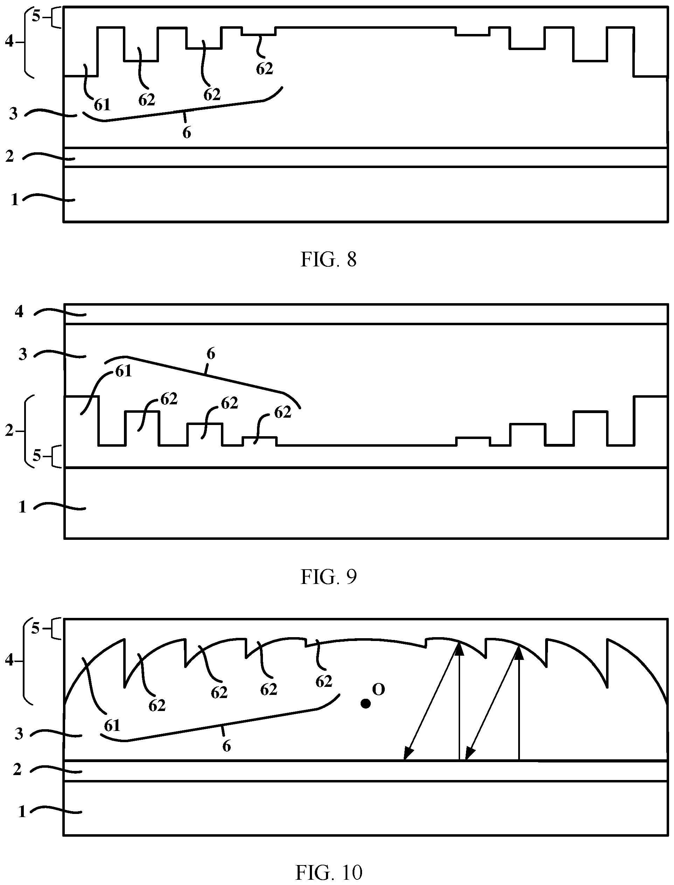

In an example, as shown in FIG. 8, the second electrode layer 4 includes the first protrusion 6, and a cross-sectional shape of the first protrusion 6 along the height direction may be rectangular. In another example, as shown in FIG. 9, the first electrode layer 4 includes the first protrusion 6, and a cross-sectional shape of the first protrusion 6 along the height direction may be rectangular.

In an example, as shown in FIG. 10, the first protrusion 6 may be a Fresnel mirror structure. Spherical centers of spherical surfaces of the first protrusion 6 and the center of the piezoelectric layer 3 are all located on the same side of a main body 5 on which the first protrusion 6 is located. The Fresnel mirror structure is a structure including a plurality of concentrically arranged spherical surfaces.

In an example, the first protrusion 6 is the Fresnel mirror structure. A direction of electric field strength between the first electrode layer 2 and the second electrode layer 4 can be enabled to bias toward the first electrode layer 2 or the second electrode layer 4, to cause an acoustic wave propagating inside the piezoelectric layer 3 to converge at a central axis of the piezoelectric layer 3, thereby reducing a spurious acoustic wave.

In addition, as shown in FIG. 10, when the acoustic wave propagating inside the piezoelectric layer 3 propagates to an interface between the piezoelectric layer 3 and an electrode layer including the first protrusion 6, the acoustic wave is reflected, and the acoustic wave is reflected toward a position biased toward a center O of the piezoelectric layer 3. In this way, transverse leakage of an acoustic wave can be reduced. Moreover, after the acoustic wave is reflected for multiple times, transverse component of the acoustic wave is gradually attenuated, and longitudinal component of the acoustic wave is gradually strengthened, thereby reducing a spurious acoustic wave having the transverse component.

It can be learned that the first protrusion 6 that is the Fresnel mirror structure can further reduce transverse leakage of an acoustic wave, increase a Q value of the resonator, and reduce an energy loss. In addition, the spurious acoustic wave can be further reduced, a transverse spurious mode generated by the spurious acoustic wave can be effectively suppressed, a phase noise of the resonator can be reduced, and a phase noise characteristic of the resonator can be improved.

As shown in FIG. 10, the second electrode layer 4 may include the first protrusion 6 that is the Fresnel mirror structure. Spherical centers of spherical surfaces of the first protrusion 6 and the center O of the piezoelectric layer 3 are located on the same side.

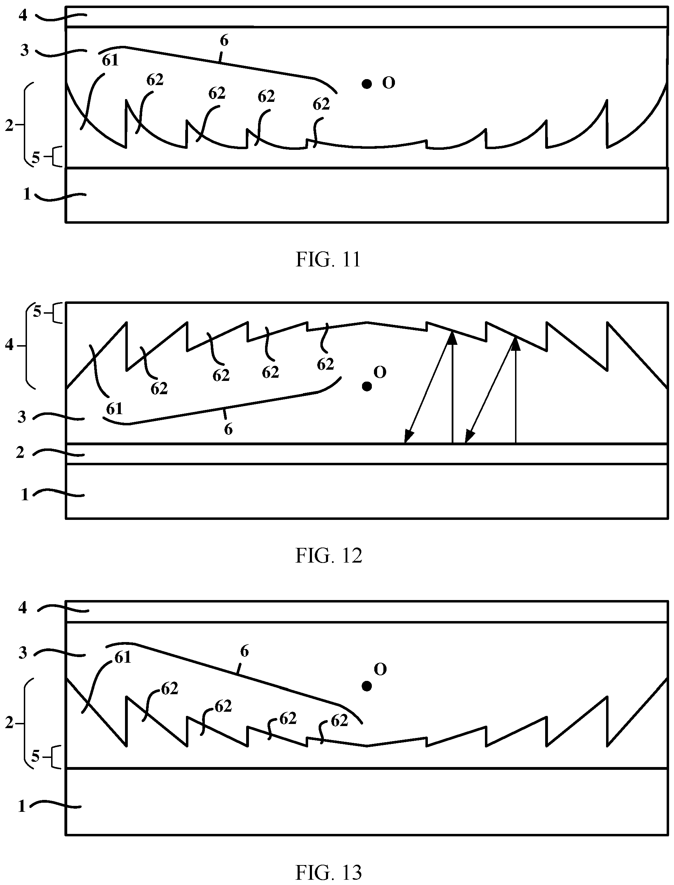

As shown in FIG. 11, the first electrode layer 2 may include the first protrusion 6 that is a Fresnel mirror structure. Spherical centers of spherical surfaces of the first protrusion 6 and the center O of the piezoelectric layer 3 are located on the same side.

Certainly, the first electrode layer 2 and a second electrode layer 4 may also each include the first protrusion 6 that is the Fresnel mirror structure. Spherical centers of spherical surfaces of the first protrusion 6 and the center O of the piezoelectric layer 3 are located on the same side.

In an example, as shown in FIG. 12, a cross-sectional shape of the first protrusion 6 along the height direction may also be right triangular. An inclined surface of the first protrusion 6 is in contact with the piezoelectric layer 3. A normal line of the inclined surface points to the center O of the piezoelectric layer 3.

As shown in FIG. 12, the second electrode layer 4 may include the first protrusion 6. The cross-sectional shape of the first protrusion 6 may also be right triangular. In this case, the first edge protrusion 61 and the first inner protrusion 62 each have an inclined surface. A normal line of the inclined surface point to the center O of the piezoelectric layer 3.

Then, an effect of the first protrusion 6 with this structure is similar to that of the Fresnel mirror structure. A direction of electric field strength between the first electrode layer 2 and the second electrode layer 4 can be enabled to bias toward the first electrode layer 2 or the second electrode layer 4, to cause an acoustic wave propagating inside the piezoelectric layer 3 to converge at the central axis of the piezoelectric layer 3, thereby reducing transverse leakage of an acoustic wave and reducing a spurious acoustic wave.

In addition, as shown in FIG. 12, when the acoustic wave propagating inside the piezoelectric layer 3 propagates to the interface between the piezoelectric layer 3 and the electrode layer including the first protrusion 6, the acoustic wave is reflected, and the acoustic wave is reflected toward a position close to the center O of the piezoelectric layer 3. The acoustic wave is caused to converge at the central axis of the piezoelectric layer 3, thereby reducing transverse leakage of an acoustic wave. Moreover, after multiple reflections, transverse component of the acoustic wave is gradually attenuated, and longitudinal component of the acoustic wave is gradually strengthened, thereby reducing a spurious acoustic wave having the transverse component.

It can be learned that the first protrusion 6 having the inclined surface can further reduce transverse leakage of an acoustic wave, increase a Q value of the resonator, and reduce an energy loss. In addition, a spurious acoustic wave can be further reduced and a transverse spurious mode generated by the spurious acoustic wave can be suppressed, so that a phase noise of the resonator is reduced, a phase noise characteristic of the resonator is improved, thereby achieving a pure frequency of an electrical signal output by the resonator.

As shown in FIG. 13, the first electrode layer 2 may also include the first protrusion 6. A cross-sectional shape of the first protrusion 6 along the height direction may also be right triangular. An inclined surface of the first protrusion 6 is in contact with the piezoelectric layer 3. A normal line of the inclined surface points to the center O of the piezoelectric layer 3.

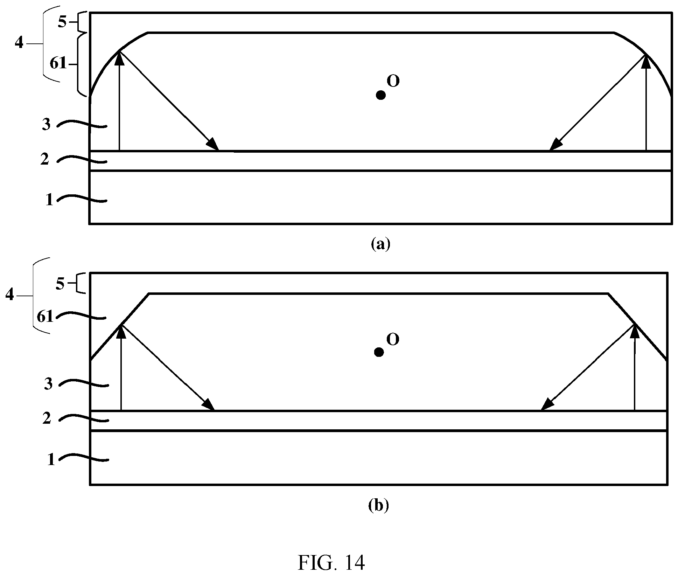

Based on the first protrusion 6 being a Fresnel mirror structure or a cross-sectional shape of the first protrusion 6 being right triangular, it may be summarized that, as shown in (a) in FIG. 14, a surface that is of the first protrusion 6 and that is close to the piezoelectric layer 3 is a spherical surface or paraboloid. The center O of the piezoelectric layer 3 is located in a space defined by the first protrusion 6. Alternatively, as shown in (b) in FIG. 14, the surface that is of the first protrusion 6 and that is close to the piezoelectric layer 3 includes an inclined surface. A normal line of the inclined surface points to the center O of the piezoelectric layer 3. The first protrusion 6 may be included in the first electrode layer 2, or may be included in the second electrode layer 4.

In some examples, at least one of the first electrode layer 2 and the second electrode layer 4 may include not only the first protrusion 61 close to the piezoelectric layer 3, but also a second protrusion 7 that is distant from the piezoelectric layer 3.

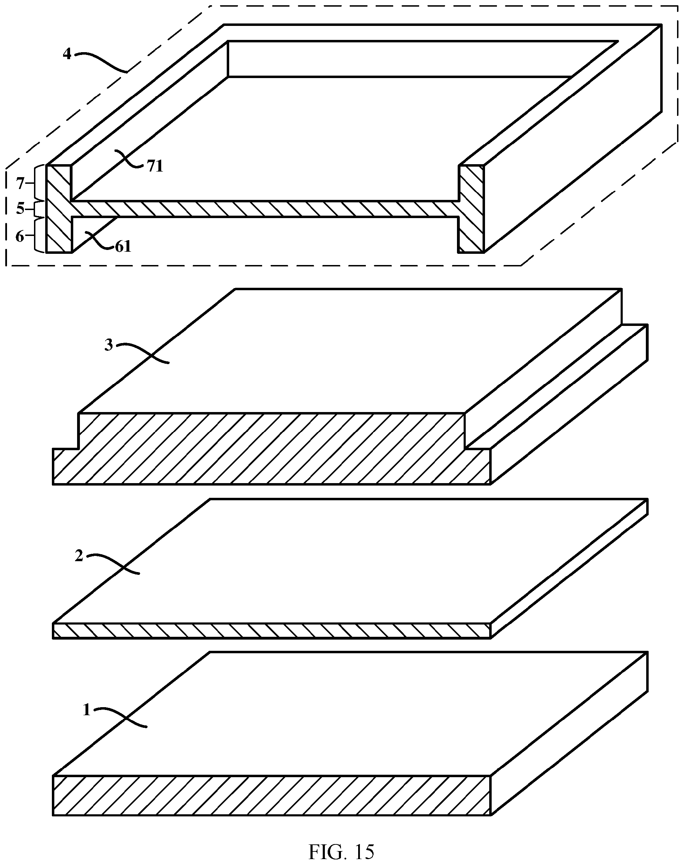

A structure of the second protrusion 7 is similar to that of the first protrusion 6, for example, the second protrusion 7 may also be a shape of in a ring. For a specific manner of forming the ring, reference may be made to the foregoing description. Details are not described herein one by one. The second protrusion 7 may also be an example of a shape of in a ring shown in FIG. 15.

As shown in FIG. 15, at least one of the first electrode layer 2 and the second electrode layer 4 includes not only the first protrusion 6, but also the second protrusion 7. The second protrusion 7 is located on a surface that is of the main body 5 and that is distant from the piezoelectric layer 3. The second protrusion 7 includes at least a second edge protrusion 71, and the second edge protrusion 71 is located at or close to an edge of the main body 5 on which the second edge protrusion 7 is located.

The second protrusion 7 and the first protrusion 6 have similar structures and functions, and a difference lies in that the first protrusion 6 is a convex ring protruding toward the piezoelectric layer 3, and the second protrusion 7 is a convex ring protruding away from the piezoelectric layer 3.

Then, as shown in FIG. 15, the second protrusion 7 may include the second edge protrusion 71, and the second edge protrusion 71 is located at or close to the edge of the main body 5 on which the second edge protrusion 7 is located.

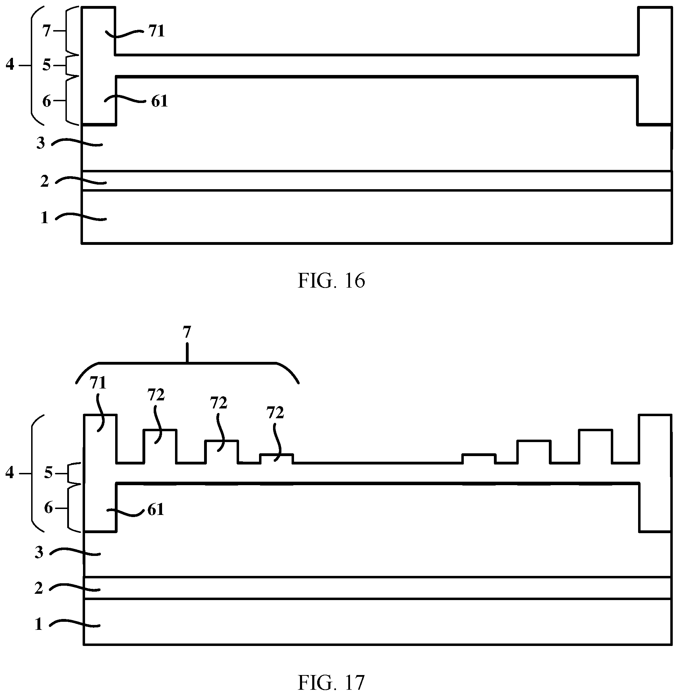

Similar to the first protrusion 6, as shown in FIG. 17, the second protrusion 7 may also include both the second edge protrusion 71 and a second inner protrusion 72. The second edge protrusion 71 and one or more second inner protrusions 72 are sequentially arranged from outside to inside, with heights decreasing sequentially. The second edge protrusion 71 and the one or more second inner protrusions 72 may also be arranged concentrically.

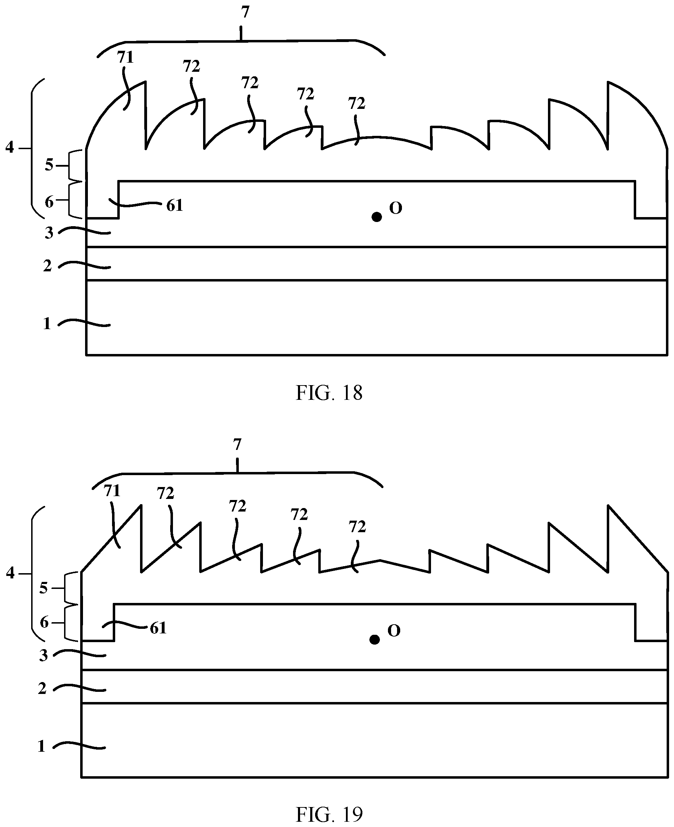

As shown in FIG. 17, a cross-sectional shape of the second protrusion 7 along a height direction may be rectangular. As shown in FIG. 18, the second protrusion 7 may also be a Fresnel mirror structure. Spherical centers of spherical surfaces of the second protrusion 7 and a center of the piezoelectric layer 3 are all located on the same side of the main body 5 on which the second protrusion 7 is located. As shown in FIG. 19, a cross-sectional shape of a second protrusion 7 along a height direction may also be right triangular. An inclined surface of the second protrusion 7 is distant from a piezoelectric layer 3. A normal line of the inclined surface points to the center O of the piezoelectric layer 3.

For effects achieved in the case that the second protrusion 7 is a Fresnel mirror structure, refer to effects achieved in the case that the first protrusion 6 is a Fresnel mirror structure. For effects achieved in the case that a cross-sectional shape of the second protrusion 7 is triangular, still refer to effects achieved in the case that a cross-sectional shape of the first protrusion 6 is triangular. Details are not described herein again.

For the same electrode layer, in a solution in which both the first protrusion 6 and the second protrusion 7 are included, a quantity of protrusions included in the first protrusion 6 may be equal to or may not be equal to a quantity of protrusions included in the second protrusion 7. The cross-sectional shape of the first protrusion 6 and the cross-sectional shape of the second protrusion 7 may be the same or different. For example, for the same electrode layer, in the solution in which both the first protrusion 6 and the second protrusion 7 are included, the first protrusion 6 and the second protrusion 7 may be mirror-symmetric relative to a main body 5. The foregoing is not limited in this embodiment, and may be flexibly selected according to an actual situation.

Based on the second protrusion 7 being the Fresnel mirror structure or the cross-sectional shape of the second protrusion 7 being right triangular, it may be summarized as follows. A surface that is of the second protrusion 7 and that is distant from the piezoelectric layer 3 is a spherical surface or paraboloid. The center O of the piezoelectric layer 3 is located in a space defined by a curved surface of the second protrusion 7. Alternatively, the surface that is of the second protrusion 7 and that is distant from the piezoelectric layer 3 includes an inclined surface. A normal line of the inclined surface points to the center O of the piezoelectric layer 3. The second protrusion 7 may be included in the first electrode layer 2, or may be included in the second electrode layer 4.

As described above, at least one of the first electrode layer 2 and the second electrode layer 4 includes the first protrusion 6, and there are the following three solutions: In a first solution, the first electrode layer 2 includes the first protrusion 6, and the second electrode layer 4 does not include the first protrusion 6. In a second solution, the second electrode layer 4 includes the first protrusion 6, and the first electrode layer 2 does not include the first protrusion 6. In a third solution, the first electrode layer 2 and the second electrode layer 4 each include the first protrusion 6.

The first protrusion 6 in each solution may include a first edge protrusion 61, but does not include a first inner protrusion 62, or may include both the first edge protrusion 61 and the first inner protrusion 62.

It should be noted that, in the foregoing first solution, the first electrode layer 2 may include the second protrusion 7, or the second electrode layer 4 may include the second protrusion 7.

In the foregoing second solution, the first electrode layer 2 may include the second protrusion 7, or the second electrode layer 4 may include the second protrusion 7, as shown in FIG. 17.

In the third solution, the first electrode layer 2 may include the second protrusion 7, or the second electrode layer 4 may include the second protrusion 7.

The second protrusion 7 in each solution may include a second edge protrusion 71, but does not include a second inner protrusion 72, or may include both the second edge protrusion 71 and the second inner protrusion 72.

It should be noted that, in the solution in which the first electrode layer 2 includes the second protrusion 7, because the second protrusion 7 protrudes away from the piezoelectric layer 3, and the first electrode layer 2 is located between a substrate 1 and the piezoelectric layer 3, the second protrusion 7 protrudes toward the substrate 1. For this situation, an upper surface that is of the substrate 1 and that is close to the first electrode layer 2 has a structure that fits with the second protrusion 7, and the substrate 1 and the first electrode layer 2 are in an engagement state.

In the foregoing solutions, an effect achieved by strengthening the first protrusion 6 through the second protrusion 7 can further reduce transverse leakage of an acoustic wave, increase a Q value of a resonator, and reduce an insertion loss. In addition, a spurious acoustic wave can be further reduced and a transverse spurious mode generated by the spurious acoustic wave can be suppressed, so that a phase noise of the resonator is reduced, and a phase noise characteristic of the resonator is improved, thereby achieving a pure frequency of an electrical signal output by the resonator.

As shown in FIG. 2 and with reference to FIG. 3, a contour shape of the resonator in a top view may be rectangular. A shape of the top view of the resonator may also be a circle, or may be triangular, an irregular quadrilateral, an irregular pentagon, or the like. A shape of the top view of the first protrusion 6 may be similar to the shape of the top view of the resonator, and may be a rectangular ring, a triangular ring, an irregular quadrilateral ring, an irregular pentagon ring, or the like. Similarly, a shape of the top view of the second protrusion 7 may be similar to the shape of the top view of the resonator, and may be a rectangular ring, a triangular ring, an irregular quadrilateral ring, an irregular pentagon ring, or the like. The foregoing is not limited in this embodiment, and may be flexibly selected according to an actual situation.

For dimensions of the substrate 1, the first electrode layer 2, the piezoelectric layer 3, and the second electrode layer 4 of the resonator, the substrate 1 is used as a support layer, and area of the substrate 1 on a horizontal plane may be larger than area of the first electrode layer 2, the piezoelectric layer 3, and the second electrode layer 4 on the horizontal plane. As shown in FIG. 1, the area of the first electrode layer 2 on the horizontal plane may be larger than the area of the piezoelectric layer 3 on the horizontal plane. The area of the piezoelectric layer 3 on the horizontal plane may be equal to the area of the second electrode layer 4 on the horizontal plane. As shown in FIG. 2 and with reference to FIG. 3, the area of the first electrode layer 2, the piezoelectric layer 3, and the second electrode layer 4 on the horizontal plane may be equal. In this embodiment, the area of the first electrode layer 2, the piezoelectric layer 3, and the second electrode layer 4 on the horizontal plane is not specifically limited, provided that the area can facilitate the following effects: A direction of electric field strength between the first electrode layer 2 and the second electrode layer 4 is biased toward the center of the first electrode layer 2 or the center of the second electrode layer 4, and an acoustic wave propagating inside the piezoelectric layer 3 converges at the central axis of the piezoelectric layer 3.

The structure of the resonator is described above, and materials of the substrate 1, the first electrode layer 2, the piezoelectric layer 3 and the second electrode layer 4 may be selected from the following.

The material of the substrate 1 may be a silicon-containing material such as silicon or silicon oxide. The materials of the first electrode layer 2 and the second electrode layer 4 may be selected from metal materials such as tungsten W, molybdenum Mo, copper Cu, iridium Ir, aluminum Al, germanium Ge, gold Au, silver Ag, tungsten W, platinum Pt, and ruthenium Ru. The materials of the first electrode layer 2 and the second electrode layer 4 may be the same or different. The material of the piezoelectric layer 3 may be selected from a piezoelectric material such as aluminum nitride AlN, zinc oxide ZnO, and lead zirconate titanate PZT.

In addition, if the first electrode layer 2 includes the main body 5 and the first protrusion 6, or the first electrode layer 2 includes the main body 5 and a second protrusion 7, or the first electrode layer 2 includes the main body 5, the first protrusion 6, and the second protrusion 7, materials of the main body 5 and the first protrusion 6 may be the same or different, and materials of the main body 5 and the second protrusion 7 may also be the same or different. Similarly, for the second electrode layer 4, if the second electrode layer 4 includes the main body 5 and the first protrusion 6, or the second electrode layer 4 includes the main body 5 and the second protrusion 7, or the second electrode layer 4 includes the main body 5, the first protrusion 6, and the second protrusion 7, materials of the main body 5 and the first protrusion 6 may be the same or different, and materials of the main body 5 and the second protrusion 7 may also be the same or different.

In an example, the first protrusion 6 or the second protrusion 7 may be prepared by using a material with a high volume specific capacitance. The volume specific capacitance is electricity quantity that can be discharged by per unit volume of material. When the first protrusion 6 or the second protrusion 7 is prepared using the material with the high volume specific capacitance, a small size can achieve a large quantity of charges. The direction of the electric field strength of the electric field between the first electrode layer 2 and the second electrode layer 4 can be better converged at the central axis of the piezoelectric layer 3, facilitating the miniaturization of the resonator.

A processing process of the foregoing resonator is described below.

The resonator may be formed in a manner of deposition and etching.

For example, a manner of processing the resonator may be to deposit the first electrode layer 2 on a surface of the substrate 1. If the first electrode layer 2 of the resonator to be processed is intended to include the second protrusion 7, the substrate 1 can be etched first, to form a structure that fits with the second protrusion 7, and then deposit the first electrode layer 2 on the etched substrate 1.

Then, the piezoelectric layer 3 is deposited on the first electrode layer 2. If the first electrode layer 2 of the resonator is intended to include the first protrusion 6, the first electrode layer 2 can be etched first, to form the first protrusion 6, and then the piezoelectric layer 3 is deposited on the first electrode layer 2 including the main body 5 and the first protrusion 6.

After that, the second electrode layer 4 is deposited on a surface of the piezoelectric layer 3. If the processed resonator is intended to include the first protrusion 6, the piezoelectric layer 3 can be etched first, to form a structure that fits with the first protrusion 6, and then the second electrode layer 4 is deposited on the etched piezoelectric layer 3. If the second electrode layer 4 of the processed resonator is intended to include the second protrusion 7, the second electrode layer 4 can be etched again, to form the second protrusion 7.

For another example, another manner of processing the resonator may be to process first to obtain the substrate 1, the first electrode layer 2, the piezoelectric layer 3, and the second electrode layer 3. The substrate 1, the first electrode layer 2, the piezoelectric layer 3, and the second electrode layer 4 may be processed in parallel or one by one. Then, the first electrode layer 2 may be fixed to the surface of the substrate 1 by bonding or direct bonding, and the piezoelectric layer 3 may be fixed to a surface that is of the first electrode layer 2 and that is distant from the substrate 1 by bonding or direct bonding. The second electrode layer 4 may also be fixed to a surface that is of the piezoelectric layer 3 and that is distant from the first electrode layer 2 by bonding or direct bonding.

If the first electrode layer 2 of the processed resonator is intended to include the second protrusion 7, the substrate 1 can be etched when the substrate 1 is processed, to form a structure that fits with the second protrusion 7 of the first electrode layer 2. When the first electrode layer 2 is processed, the first electrode layer 2 is etched, to form the second protrusion 7.

If the first electrode layer 2 of the processed resonator is intended to include the first protrusion 6, the first electrode layer 2 can be etched when the first electrode layer 2 is processed, to form the first protrusion 6.

If the second electrode layer 4 of the processed resonator is intended to include the first protrusion 6, the piezoelectric layer 3 can be etched when the piezoelectric layer 3 is processed, to form the structure that fits with the first protrusion 6, and the second electrode layer 4 can be etched, to form the first protrusion 6.

If the second electrode layer 4 of the processed resonator is intended to include the second protrusion 7, the second electrode layer 4 can be etched, to form the second protrusion 7.

The process of forming the resonator is not specifically limited in this embodiment, and may be flexibly selected according to an actual situation.

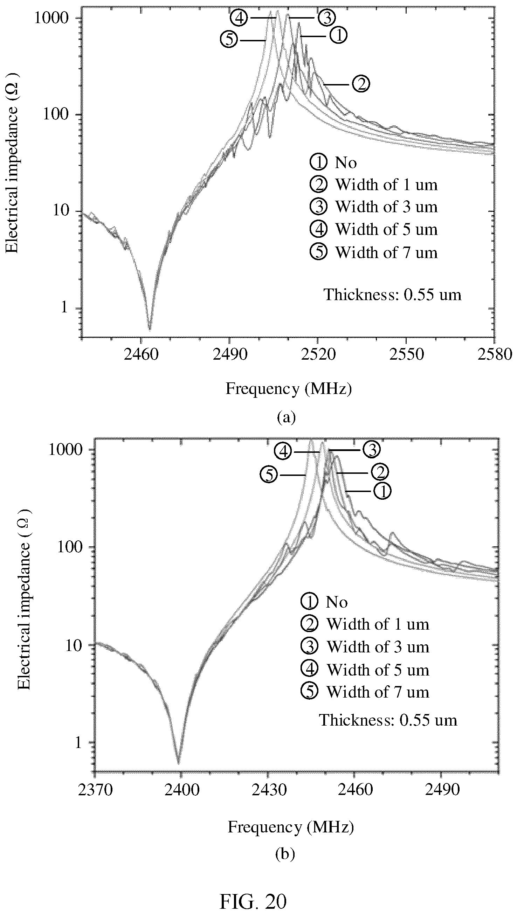

For a result of a simulation of the resonator, refer to FIG. 20. FIG. 20 is a schematic diagram of a result of a simulation based on that a second electrode layer 4 includes a first protrusion 6. (a) in FIG. 20 shows a result of a simulation based on that a reflection layer is laid on the second electrode layer 4. (b) in FIG. 20 shows a result of a simulation based on that no reflection layer is laid on the second electrode layer 4. Generally, when the resonator is encapsulated, a resin encapsulation may be used. In this case, the reflection layer, for example, a Bragg reflection layer, is laid on the second electrode layer 4, to limit an acoustic wave to propagate inside a piezoelectric layer 3. A vacuum encapsulation may also be adopted, so that the reflection layer does not need to be laid on the second electrode layer 4.

FIG. 20 is a curve of electrical impedance changing with a frequency when the resonator is converted into an equivalent circuit. A steeper curve indicates a larger Q value of the corresponding resonator. A smaller an insertion loss indicates a better frequency selection characteristic of the resonator. A smoother curve indicates a less spurious acoustic wave of the corresponding resonator, and a better phase noise characteristic of the resonator.

As shown in (a) in FIG. 20, a curve ① shows a relationship of electrical impedance of a resonator that does not include the first protrusion 6 and a second protrusion 7 as a function of the frequency. A curve ②, a curve ③, a curve (1), and a curve ⑤ show a relationship of electrical impedance of a resonator that includes the first protrusion 6 and a first edge protrusion 61 having a thickness of 0.55 micrometers and widths of 1 micrometer, 3 micrometers, 5 micrometers and 7 micrometers as a function of the frequency.

Similarly, as shown in (b) in FIG. 20, a curve ① shows a relationship of electrical impedance of a resonator that does not include the first protrusion 6 and a second protrusion 7 as a function of the frequency. A curve ②, a curve ③, a curve (1), and a curve ⑤ show a relationship of electrical impedance of a resonator that includes the first protrusion 6 and a first edge protrusion 61 having a thickness of 0.55 micrometers and widths of 1 micrometer, 3 micrometers, 5 micrometers and 7 micrometers as a function of the frequency.

It can be learned from FIG. 20 that the curve ②, the curve ③, the curve ④, and the curve ⑤ are steeper than the curve ①. In this way, a Q value of the resonator that includes the first protrusion 6 is higher than a Q value of the resonator that does not include the first protrusion 6. Therefore, the first protrusion 6 is conducive to increasing a Q value of the resonator and reduce the insertion loss.

It can also be learned from FIG. 20 that the curve ④ and the curve ⑤ are steeper. In this case, the width of the first edge protrusion 61 may be between 5 micrometers and 7 micrometers.

The result of the simulation shown in FIG. 20 is an example in which the second piezoelectric layer 4 includes the first protrusion 6. The foregoing result can also be obtained through a simulation test in which the first electrode layer 2 includes the first protrusion 6 and at least one of the first electrode layer 2 and the second electrode layer 4 includes the second protrusion 7.

The thicknesses of each protrusion in the first protrusion 6 and the widths of each protrusion may be flexibly selected based on the result of the simulation and the experimental test. The thicknesses of each protrusion in the second protrusion 7 and the widths of each protrusion may also be flexibly selected based on the result of the simulation and the experimental test. The protrusions include the first edge protrusion, a first inner protrusion, a second edge protrusion, and a second inner protrusion.

In the resonator shown in this embodiment, at least one of the first electrode layer and the second electrode layer includes the first protrusion portion protruding toward the piezoelectric layer, and the first protrusion portion includes the first edge protrusion portion. In this way, electric field strength of an electric field between the first electrode layer and the second electrode layer at an edge is greater than the field strength at a center, so that a direction of the electric field strength between the first electrode layer and the second electrode layer is biased toward a center of the first electrode layer or the second electrode layer. A propagation direction of the acoustic wave propagating inside the piezoelectric layer is related to a direction of electric field strength of the electric field, so that acoustic waves propagating inside the piezoelectric layer converge at a central axis of the piezoelectric layer, thereby enhancing a convergence effect of acoustic waves, reducing transverse leakage of an acoustic wave, increasing a Q value of the resonator, and reducing an insertion loss of the resonator.

In addition, enhancement of the convergence effect of the acoustic waves can further reduce a spurious acoustic wave and suppress a transverse spurious mode generated by the spurious acoustic wave, so that a phase noise of the resonator is reduced, and a phase noise characteristic of the resonator is improved, thereby achieving a pure frequency of an electrical signal output by the resonator.

An embodiment of this application further provides a resonator. The resonator still includes a substrate 1, a first electrode layer 2, a piezoelectric layer 3, and a second electrode layer 4 sequentially stacked. If a position where the substrate 1 is located is defined as bottom, the substrate 1, the first electrode layer 2, the piezoelectric layer 3, and the second electrode layer 4 are sequentially stacked from bottom to top.

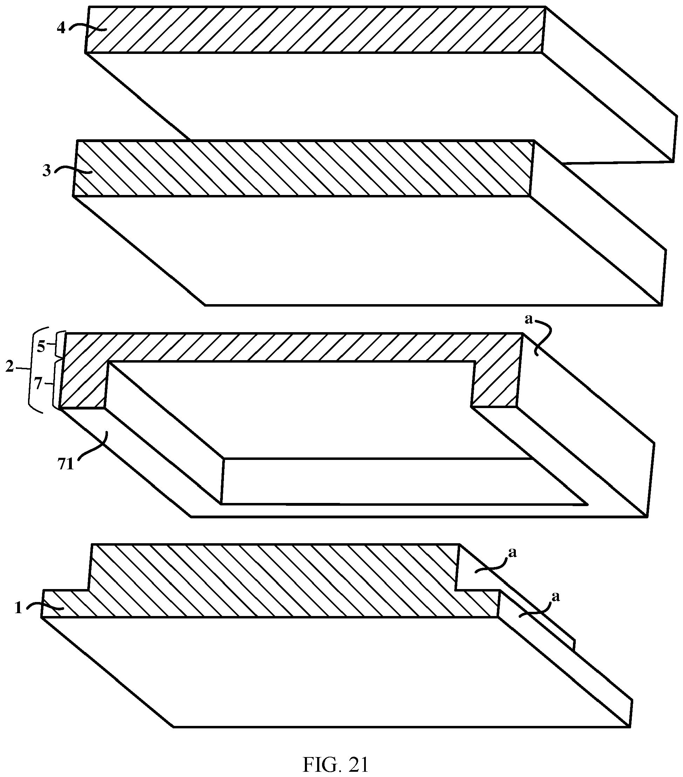

Different from the resonator described above, the first electrode layer 2 may not include a first protrusion 6, but include a second protrusion 7. As shown in FIG. 21, the first electrode layer 2 may include a main body 5 and the second protrusion 7. The second protrusion 7 is located on a surface that is of the main body 5 and that is distant from the piezoelectric layer 3. The second protrusion 7 still includes at least a second edge protrusion 71. The second edge protrusion 71 is close to a side a of the main body 5.

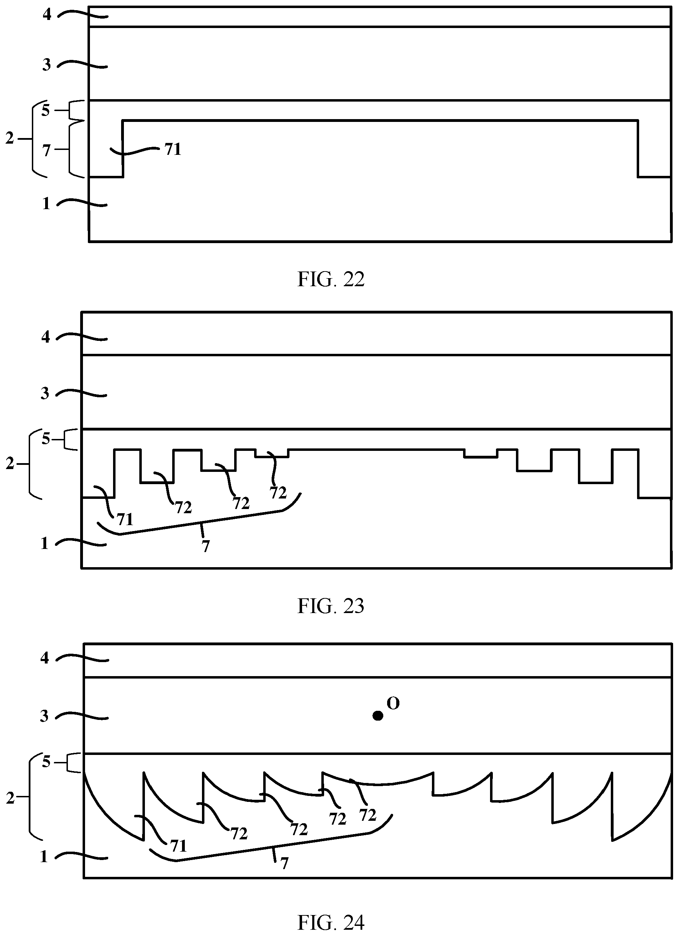

As described above, as shown in FIG. 21 and with reference to FIG. 22, the second protrusion 7 may include only the second edge protrusion 71. As shown in FIG. 23, the second protrusion 7 may also include both the second edge protrusion 71 and a second inner protrusion 72. The second edge protrusion 71 and the one or more second inner protrusions 72 are sequentially arranged from outside to inside, with heights decreasing sequentially. As described above, the second edge protrusion 71 and the one or more second inner protrusions 72 may be arranged concentrically.

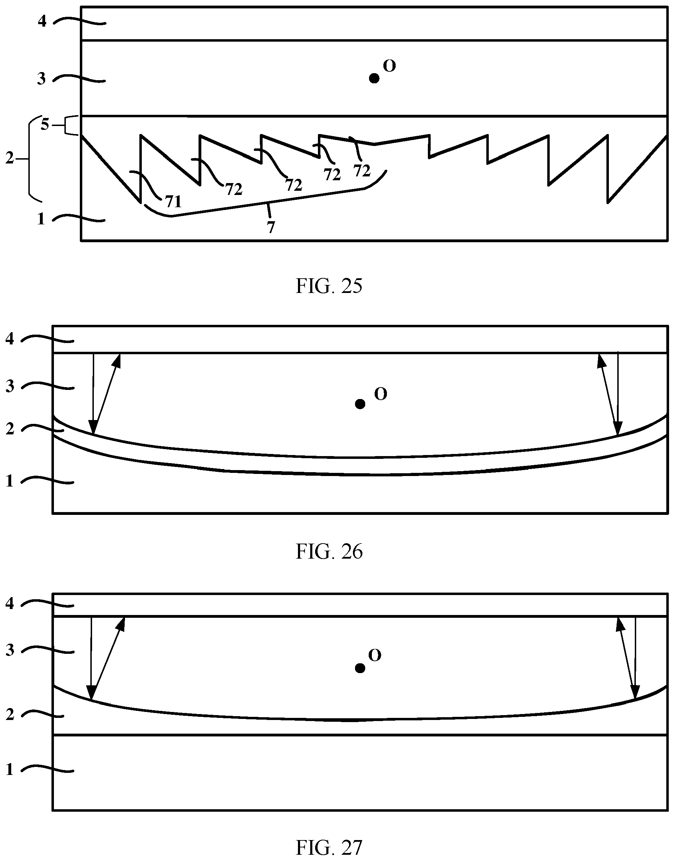

As for a shape of the second protrusion 7 of the first electrode layer 2, as shown in FIG. 23, a cross-sectional shape of the second protrusion 7 along a height direction may be rectangular. As shown in FIG. 24, the second protrusion 7 may be a Fresnel mirror structure. Spherical centers of spherical surfaces of the second protrusion 7 and a center of the piezoelectric layer 3 are all located on the same side of the main body 5 on which the second protrusion 7 is located. As shown in FIG. 25, a cross-sectional shape of the second protrusion 7 along a height direction may also be right triangular. An inclined surface of the second protrusion 7 is distant from the piezoelectric layer 3. A normal line of the inclined surface points to the center O of the piezoelectric layer 3. For effects achieved in the case that the second protrusion 7 is a Fresnel mirror structure and the cross-sectional shape of the second protrusion 7 is a right triangular, refer to the foregoing description. Details are not described herein again.

In the solution in which the first electrode layer 2 includes the second protrusion 7, at least one of the first electrode layer 2 and the second electrode layer 4 may also include the first protrusion 6. For example, the first electrode layer 2 includes the second protrusion 7 and the first protrusion 6. For another example, the second electrode layer 4 includes the second protrusion 7. For another example, the second electrode layer 4 includes the second protrusion 7 and the first protrusion 6. For descriptions of each solution, refer to the foregoing description. Details are not described herein again.

In the resonator shown in this embodiment, the first electrode layer includes the second protrusion that is distant from the piezoelectric layer, and the second protrusion includes a second edge protrusion. In this way, electric field strength of an electric field between the first electrode layer and the second electrode layer at an edge is greater than the field strength at a center, so that a direction of the electric field strength between the first electrode layer and the second electrode layer is biased toward a center of the first electrode layer or the second electrode layer. A propagation direction of an acoustic wave propagating inside the piezoelectric layer is related to a direction of electric field strength of the electric field, so that acoustic waves propagating inside the piezoelectric layer converge at a central axis of the piezoelectric layer, thereby enhancing a convergence effect of acoustic waves, reducing transverse leakage of an acoustic wave, increasing a Q value of the resonator, and reducing an insertion loss of the resonator.

In addition, enhancement of the convergence effect of the acoustic waves can further reduce a spurious acoustic wave and suppress a transverse spurious mode generated by the spurious acoustic wave, so that a phase noise of the resonator is reduced, and a phase noise characteristic of the resonator is improved, thereby achieving a pure frequency of an electrical signal output by the resonator.

An embodiment of this application further provides a resonator. As shown in FIG. 26, the resonator includes a substrate 1, the first electrode layer 2, the piezoelectric layer 3, and the second electrode layer 4 sequentially stacked. If a position where the substrate 1 is located is defined as bottom, the substrate 1, the first electrode layer 2, the piezoelectric layer 3, and the second electrode layer 4 are sequentially stacked and arranged from bottom to top.

Different from the resonator described above, a distance between the first electrode layer 2 and the second electrode layer 4 sequentially decreases from a center to an edge.

The distance between the first electrode layer 2 and the second electrode layer 4 is a distance between two surfaces that are of the first electrode layer 2 and the second electrode layer 4 and that are close to each other.

A manner of the distance between the first electrode layer 2 and the second electrode layer 4 sequentially decreases from the center to the edge may be: A first surface that is of at least one of the first electrode layer 2 and the second electrode layer 4 and that is close to the piezoelectric layer 3 is a spherical surface, a conical surface or paraboloid. A center of the piezoelectric layer 3 is located in a region defined by the first surface.

For example, as shown in FIG. 26 and FIG. 27, the first surface that is of the first electrode layer 2 and that is closed to the piezoelectric layer 3 is a spherical surface. Spherical centers and a center of the piezoelectric layer 3 are located on the same side. In other words, the piezoelectric layer 3 is located in a region defined by the spherical surface. As shown in FIG. 26, a second surface of the first electrode layer 2 that is distant from the piezoelectric layer 3 is also a spherical surface, and the first electrode layer 2 has a spherical structure of an equal thickness. As shown in FIG. 27, the first surface of the first electrode layer 2 is the spherical surface, and a second surface of the first electrode layer 2 is planar.

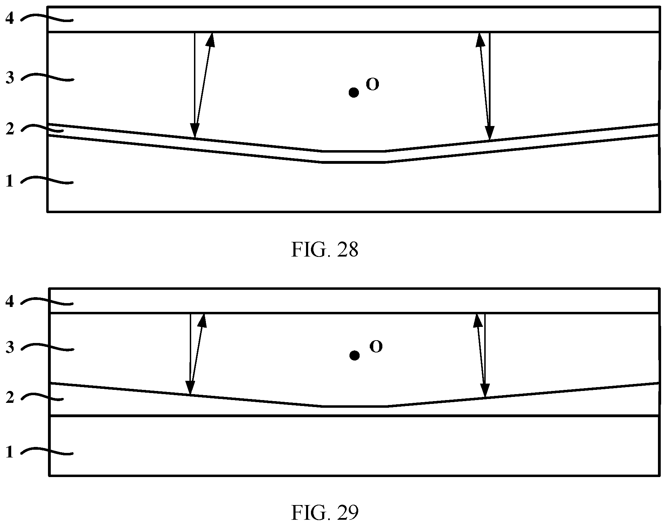

For another example, as shown in FIG. 28 and FIG. 29, a first surface that is of the first electrode layer 2 and that is close to the piezoelectric layer 3 is a conical surface, and the piezoelectric layer 3 is located in a region defined by the conical surface. As shown in FIG. 28, the first surface of the first electrode layer 2 is the conical surface, a second surface of the first electrode layer 2 that is distant from the piezoelectric layer 3 is also a conical surface, and the first electrode layer 2 has a conical structure of an equal thickness. As shown in FIG. 29, the first surface of the first electrode layer 2 is the conical surface, and a second surface of the first electrode layer 2 is planar.

For another example, the first surface of the first electrode layer 2 may be paraboloid, and the piezoelectric layer 3 may be located in a region defined by the paraboloid.

Electric field strength close to an edge between the first electrode layer 2 and the second electrode layer 4 can be enhanced by reducing a distance between the first electrode layer 2 and the second electrode layer 4, so that a direction of the electric field strength between the first electrode layer 2 and the second electrode layer 4 is biased toward the first electrode layer 2 or the second electrode layer 4. In this way, an acoustic wave propagating inside the piezoelectric layer 3 is caused to converge at a position close to a central axis of the piezoelectric layer 3, thereby enhancing a convergence effect of acoustic waves, reducing transverse leakage of an acoustic wave, increasing a Q value of a resonator, and reducing an energy loss.

A principle of increasing the electric field strength by reducing the distance is as follows: based on

$$E = k\frac{Q}{r^2}$$

an electric field strength formula , in the formula, E is the electric field strength, k is electrostatic force constant, and a value of the electrostatic force constant is $9.0*10^9$ N·m²/C², and Q is electric quantity of source charges, r is a distance between the source charges and probe charges. In this embodiment, r may be a distance at each position of the first electrode layer 2 and the second electrode layer 4. It can be learned from the foregoing formula that the electric field strength is large at position where there is a large quantity of charges and a position where the distance between the source charges and probe charges is small.

When the first surface of the first electrode layer 2 is the spherical surface, the paraboloid, or the conical surface, not only has the foregoing effects, but also the following effect can be achieved, as shown in FIG. 26 to FIG. 29, arrows indicate a propagation direction of the acoustic wave. When the acoustic wave in the piezoelectric layer 3 propagates to junction between the piezoelectric layer 3 and the first electrode layer 2, the acoustic wave can be reflected toward a position close to a center O of the piezoelectric layer 3. In this way, the acoustic wave propagating inside the piezoelectric layer 3 is caused to converge at the position close to the central axis of the piezoelectric layer 3. During multiple reflections of the acoustic wave, transverse component of the acoustic wave is gradually attenuated, so that a spurious acoustic wave having the transverse component is reduced, a transverse spurious mode generated by the spurious acoustic wave can be suppressed, a phase noise of the resonator is reduced, and a phase noise characteristic of the resonator is improved, thereby achieving a pure frequency of an electrical signal output by the resonator.

It should be noted that although FIG. 26 to FIG. 29 show that the first surface of the first electrode layer 2 is the spherical surface, the conical surface, or the paraboloid, a first surface of the second electrode layer 4 may also be a spherical surface, a conical surface, or paraboloid. For a case in which the first surface of the second electrode layer 4 may also be the spherical surface, the conical surface, or the paraboloid, refer to the foregoing description. Details are not described herein again.

It should be noted that, in the solution in which the distance between the first electrode layer 2 and the second electrode layer 4 sequentially decreases from the center to the edge, the first electrode layer 2 may include the foregoing first protrusion 6, or may include the second protrusion 7. The second electrode layer 4 may also include the foregoing first protrusion 6, or may include the second protrusion 7. For a specific structure, refer to the foregoing description about the first protrusion 6 and the foregoing description about the second protrusion 7.

According to the resonator shown in embodiments, the electric field strength close to the edge between the first electrode layer and the second electrode layer is enhanced by reducing the distance between the first electrode layer and the second electrode layer, so that the direction of the electric field strength between the first electrode layer and the second electrode layer is biased toward the center of the first electrode layer or of the second electrode layer. In this way, acoustic waves propagating inside the piezoelectric layer are caused to converge at the position close to the central axis of the piezoelectric layer, thereby enhancing a convergence effect of acoustic waves, reducing transverse leakage of an acoustic wave, increasing a Q value of the resonator, and reducing an energy loss.

In addition, a spurious acoustic wave can be further reduced and a transverse spurious mode generated by the spurious acoustic wave can be suppressed, so that a phase noise of the resonator is reduced, a phase noise characteristic of the resonator is improved, thereby achieving a pure frequency of an electrical signal output by the resonator.

An embodiment of this application further provides an electronic component. The electronic component may include the resonator in any one of the foregoing embodiments.

The electronic component may be any component related to frequency signal output or frequency selection, such as an oscillator, a filter, or a clock communication component.

The resonator of the electronic component, as described above, can enhance the electric field strength close to the edge between the first electrode layer and the second electrode layer, so that the direction of the electric field strength between the first electrode layer and the second electrode layer is biased toward the first electrode layer or the second electrode layer. In this way, an acoustic wave propagating inside a piezoelectric layer is caused to converge at a position close to a central axis of the piezoelectric layer, thereby enhancing a convergence effect of acoustic waves, reducing transverse leakage of an acoustic wave, increasing a Q value of the resonator, and reducing an energy loss.

In addition, enhancement of the convergence effect of the acoustic waves can further reduce a spurious acoustic wave and suppress a transverse spurious mode generated by the spurious acoustic wave, so that a phase noise of the resonator is reduced, and a phase noise characteristic of the resonator is improved, thereby achieving a frequency of an electrical signal output by the resonator.

The foregoing descriptions are merely an embodiment of this application, but are not intended to limit this application. Any modification, equivalent replacement, or improvement made without departing from the principle of this application shall fall within the protection scope of this application.

## Claims

1. A resonator, wherein the resonator comprises a substrate (1), a first electrode layer (2), a piezoelectric layer (3), and a second electrode layer (4) sequentially stacked;

   at least one of the first electrode layer (2) and the second electrode layer (4) comprises a first protrusion (6), and the first protrusion (6) protrudes toward the piezoelectric layer (3); and the first protrusion (6) comprises at least a first edge protrusion (61), and the first edge protrusion (61) surrounds at least a part of a side (a) of the piezoelectric layer (3).

2. The resonator according to claim 1, wherein the first protrusion (6) further comprises one or more first inner protrusions (62); and the first edge protrusion (61) and the one or more first inner protrusions (62) are sequentially arranged from outside to inside, with heights decreasing sequentially.

3. The resonator according to claim 2, wherein the first edge protrusion (61) and the one or more first inner protrusions (62) are arranged concentrically.

4. The resonator according to claim 2 or 3, wherein the first protrusion (6) is a Fresnel mirror structure, and spherical centers of spherical surfaces of the first protrusion (6) and a center of the piezoelectric layer (3) are all located on a same side of the first protrusion (6).

5. The resonator according to any one of claims 1 to 3, wherein a cross-sectional shape of the first protrusion (6) along a height direction is rectangular.

6. The resonator according to any one of claims 1 to 3, wherein a cross-sectional shape of the first protrusion (6) along a height direction is right triangular, an inclined surface of the first protrusion (6) is in contact with the piezoelectric layer (3), and a normal line of the inclined surface points to a center (O) of the piezoelectric layer (3).

7. The resonator according to any one of claims 1 to 6, wherein at least one of the first electrode layer (2) and the second electrode layer (4) further comprises a second protrusion (7), the second protrusion (7) is distant from the piezoelectric layer (3), and the second protrusion (7) comprises at least a second edge protrusion (71).

8. The resonator according to claim 7, wherein the second protrusion (7) further comprises one or more second inner protrusions (72); and the second edge protrusion (71) and the one or more second inner protrusions (72) are sequentially arranged from outside to inside, with heights decreasing sequentially.

9. The resonator according to claim 8, wherein the second edge protrusion (71) and the one or more second inner protrusions (72) are arranged concentrically.

10. The resonator according to claim 8 or 9, wherein the second protrusion (7) is a Fresnel mirror structure, and spherical centers of spherical surfaces of the second protrusion (7) and the center of the piezoelectric layer (3) are all located on a same side of the second protrusion (7).

11. The resonator according to any one of claims 7 to 9, wherein a cross-sectional shape of the second protrusion (7) along a height direction is rectangular.

12. The resonator according to any one of claims 7 to 9, wherein a cross-sectional shape of the second protrusion (7) along a height direction is right triangular, an inclined surface of the second protrusion (7) is distant from the piezoelectric layer (3), and a normal line of the inclined surface points to the center (O) of the piezoelectric layer (3).

13. A resonator, wherein the resonator comprises a substrate (1), a first electrode layer (2), a piezoelectric layer (3), and a second electrode layer (4) sequentially stacked;

the first electrode layer (2) comprises a second protrusion (7), and the second protrusion (7) is distant from the piezoelectric layer (3); and
the second protrusion (7) comprises at least a second edge protrusion (71).

14. The resonator according to claim 13, wherein the second protrusion (7) further comprises one or more second inner protrusions (72); and
the second edge protrusion (71) and the one or more second inner protrusions (72) are sequentially arranged from outside to inside, with heights decreasing sequentially.

15. The resonator according to claim 14, wherein the second edge protrusion (71) and the one or more second inner protrusions (72) are arranged concentrically.

16. The resonator according to claim 14 or 15, wherein the second protrusion (7) is a Fresnel mirror structure, and spherical centers of spherical surfaces of the second protrusion (7) and a center of the piezoelectric layer (3) are all located on a same side of the second protrusion (7).

17. The resonator according to any one of claims 13 to 16, wherein a cross-sectional shape of the second protrusion (7) along a height direction is rectangular.

18. The resonator according to any one of claims 13 to 16, wherein a cross-sectional shape of the second protrusion (7) along a height direction is right triangular, an inclined surface of the second protrusion (7) is distant from the piezoelectric layer (3), and a normal line of the inclined surface points to a center (O) of the piezoelectric layer (3).

19. A resonator, wherein the resonator comprises a substrate (1), a first electrode layer (2), a piezoelectric layer (3), and a second electrode layer (4) sequentially stacked; and
a distance between the first electrode layer (2) and the second electrode layer (4) sequentially decreases from a center to an edge.

20. The resonator according to claim 19, wherein a first surface that is of at least one electrode layer of the first electrode layer (2) and the second electrode layer (4) and that is close to the piezoelectric layer (3) is one of a spherical surface, a conical surface and paraboloid, and a center of the piezoelectric layer (3) is located in a region defined by the first surface.

21. An electronic component, wherein the electronic component comprises the resonator according to any one of claims 1 to 20.

**(a)**

**(b)**

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

(a)

(b)

FIG. 14

FIG. 15

FIG. 16

FIG. 17

FIG. 18

FIG. 19

(a)

(b)

FIG. 20

FIG. 21

FIG. 22

FIG. 23

FIG. 24

FIG. 25

FIG. 26

FIG. 27

FIG. 28

FIG. 29

## INTERNATIONAL SEARCH REPORT

| International application No. |
| --- |
| **PCT/CN2022/074812** |

### A. CLASSIFICATION OF SUBJECT MATTER

H03H 9/02(2006.01)i

According to International Patent Classification (IPC) or to both national classification and IPC

### B. FIELDS SEARCHED

Minimum documentation searched (classification system followed by classification symbols)

H03H9/-

Documentation searched other than minimum documentation to the extent that such documents are included in the fields searched

Electronic data base consulted during the international search (name of data base and, where practicable, search terms used)

CNTXT; ENTXT; ENTXTC; VEN; CNKI: 谐振器, 压电, 电极, 凸起, 突起, 边缘, 衬底, 距离, 厚度, 中心, resonator, substrate, electrode, thickness, base, piezoelectric

### C. DOCUMENTS CONSIDERED TO BE RELEVANT

| Category* | Citation of document, with indication, where appropriate, of the relevant passages | Relevant to claim No. |
| --- | --- | --- |
| X | CN 104753493 A (GUIZHOU HUNTERSUN ELECTRONIC CO., LTD.) 01 July 2015 (2015-07-01) description, paragraphs [0027]-[0038], and figures 2a and 2b | 1, 5, 21 |
| A | CN 111211757 A (HANGZHOU JIANWENLU TECHNOLOGY CO., LTD.) 29 May 2020 (2020-05-29) entire document | 1-12, 21 |
| A | US 2018152168 A1 (SAMSUNG ELECTRO-MECHANICS CO., LTD.) 31 May 2018 (2018-05-31) entire document | 1-12, 21 |

☐ Further documents are listed in the continuation of Box C. ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **02 March 2022** | **24 April 2022** |

| Name and mailing address of the ISA/CN | Authorized officer |
| --- | --- |
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

## INTERNATIONAL SEARCH REPORT

International application No.

**PCT/CN2022/074812**

| Box No. III | Observations where unity of invention is lacking (Continuation of item 3 of first sheet) |
| --- | --- |

This International Searching Authority found multiple inventions in this international application, as follows:

[1]   claims 1-12 and 21; claims 13-18 and, 21; and claims 19-21

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☑ No required additional search fees were timely paid by the applicant. Consequently, this international search report is restricted to the invention first mentioned in the claims; it is covered by claims Nos.: **claims 1-12 and 21**

**Remark on Protest**   ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet) (January 2015)

**INTERNATIONAL SEARCH REPORT**
**Information on patent family members**

International application No.

**PCT/CN2022/074812**

| Patent document cited in search report | | | Publication date (day/month/year) | Patent family member(s) | | | Publication date (day/month/year) |
|---|---|---|---|---|---|---|---|
| CN | 104753493 | A | 01 July 2015 | CN | 104753493 | B | 25 August 2017 |
| CN | 111211757 | A | 29 May 2020 | None | | | |
| US | 2018152168 | A1 | 31 May 2018 | US | 10903814 | B2 | 26 January 2021 |
| | | | | CN | 108123695 | A | 05 June 2018 |
| | | | | KR | 20180062323 | A | 08 June 2018 |
| | | | | KR | 101973435 | B1 | 29 April 2019 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202110484760
- CN 202110866593X

- CN 202121757671